(19) Europäisches Patentamt / European Patent Office / Office européen des brevets

(11) **EP 2 011 160 B1**

(12) **EUROPÄISCHE PATENTSCHRIFT**

(45) Veröffentlichungstag und Bekanntmachung des Hinweises auf die Patenterteilung:
**15.08.2018  Patentblatt 2018/33**

(21) Anmeldenummer: **07722113.3**

(22) Anmeldetag: **26.03.2007**

(51) Int Cl.:
*H01L 33/14* (2010.01)   *H01L 33/20* (2010.01)
*H01L 33/40* (2010.01)   *H01L 33/38* (2010.01)
*H01L 33/00* (2010.01)   *H01L 33/42* (2010.01)

(86) Internationale Anmeldenummer:
**PCT/DE2007/000554**

(87) Internationale Veröffentlichungsnummer:
**WO 2007/124708 (08.11.2007 Gazette 2007/45)**

(54) **OPTOELEKTRONISCHER HALBLEITERCHIP**

OPTOELECTRONIC SEMICONDUCTOR CHIP

PUCE À SEMI-CONDUCTEUR OPTOÉLECTRONIQUE

(84) Benannte Vertragsstaaten:
**DE**

(30) Priorität: **27.04.2006  DE 102006019725
27.07.2006  DE 102006034847**

(43) Veröffentlichungstag der Anmeldung:
**07.01.2009  Patentblatt 2009/02**

(73) Patentinhaber: **OSRAM Opto Semiconductors GmbH
93055 Regensburg (DE)**

(72) Erfinder: **ILLEK, Stefan
93093 Donaustauf (DE)**

(74) Vertreter: **Epping - Hermann - Fischer
Patentanwaltsgesellschaft mbH
Schloßschmidstraße 5
80639 München (DE)**

(56) Entgegenhaltungen:
**EP-A- 1 523 047          EP-A2- 1 592 072
WO-A-02/45217            WO-A-2005/117147
US-A- 5 789 768          US-A1- 2001 011 730
US-A1- 2004 135 166      US-A1- 2004 206 961
US-A1- 2005 205 875**

**Beschreibung**

Die vorliegende Erfindung betrifft einen optoelektronischen Halbleiterchip.

In der WO 2005/117147 A1 ist ein Herstellungsverfahren für einen Bereich einer III-V-Halbleiterschicht beschrieben, die eine reduzierte elektrische Leitfähigkeit aufweist.

Die US 5789768 A beschreibt eine lichtemittierende Diode, welche eine Kontaktschicht aufweist, über welche in die LED bereichsweise Strom einprägbar ist.

Die EP 1523047 A beschreibt ein mit Nitrid gebildetes lichtemittierendes Bauteil, welches über eine ohmsche Kontaktschicht elektrisch kontaktierbar ist, wobei die Kontaktschicht mit einem Zink umfassenden Oxid gebildet ist.

Die US 2001/011730 A1 beschreibt ein lichtemittierendes Halbleiterbauteil, bei dem mittels Stromblockierschichten das Abstrahlprofil beeinflusst wird.

Die US 20040135166 A1 beschreibt ein lichtemittierendes Bauteil, bei dem zwischen einer lichtemittierenden Schicht und einer ITO-Schicht bereichsweise eine Kontaktschicht angeordnet ist.

Die WO 02/45217 beschreibt einen VCSEL mit einem oberen und einem unteren Spiegel, bei dem zwischen dem oberen Spiegel und dem unteren Spiegel teilweise eine isolierende Schicht angeordnet ist.

Die US 2004/0206961 A1 beschreibt ein lichtemittierendes Bauteil, welches über eine transparente Oxidschicht elektrisch leitend kontaktierbar ist.

Die EP 1592072 A2 beschreibt einen strahlungsemittierenden Halbleiterchip mit einer Halbleiterdünnschicht in der ein Graben ausgebildet ist. Eine dielektrische Schicht auf der Halbleiterdünnschicht ist in Bereichen außerhalb des Grabens von Durchkontaktierungen durchbrochen. Auf der der Halbleiterdünnschicht abgewandten Seite der dielektrischen Schicht ist eine Spiegelschicht angeordnet.

Eine Aufgabe der vorliegenden Erfindung ist es, einen strahlungsemittierenden Halbleiterchip mit hoher Auskoppeleffizienz anzugeben, der vereinfacht herstellbar ist. Insbesondere soll ein oberflächenstrahlender Halbleiterchip angegeben werden, der den Großteil der gesamten aus dem Chip ausgekoppelten Strahlungsleistung über eine Oberseite des Chips abstrahlt. Zudem soll ein vereinfachtes Verfahren zur Herstellung einer Kontaktstruktur für einen zur Strahlungserzeugung geeigneten optoelektronischen Halbleiterchip mit hoher Auskoppeleffizienz angegeben werden.

Hierbei ist unter dem Begriff "Oberseite" vorzugsweise eine einer Montageseite des Halbleiterchips für die Montage des Chips auf einem externen Anschlussleiter abgewandte Seite des Halbleiterchips zu verstehen.

Diese Aufgabe wird durch einen Halbleiterchip mit den Merkmalen des Patentanspruchs 1 gelöst. Vorteilhafte Ausgestaltungen und Weiterbildungen der Erfindung sind Gegenstand der abhängigen Patentansprüche.

Ein erfindungsgemäßer optoelektronischer Halbleiterchip weist einen Halbleiterkörper auf, der eine Halbleiterschichtenfolge und einen zur Strahlungserzeugung geeigneten aktiven Bereich umfasst. Ferner weist der Halbleiterchip eine auf dem Halbleiterkörper angeordnete und elektrisch leitend mit dem aktiven Bereich verbundene strahlungsdurchlässige und elektrisch leitfähige Kontaktschicht auf. Diese Kontaktschicht erstreckt sich über eine Barriereschicht der Halbleiterschichtenfolge und über eine Anschlussschicht der Halbleiterschichtenfolge. Dabei ist die Kontaktschicht über einen Anschlussbereich der Anschlussschicht mit dem aktiven Bereich elektrisch leitend verbunden.

Gegenüber einer stark absorbierenden Kontaktschicht, etwa einer dicken Metallschicht weist die strahlungsdurchlässige Kontaktschicht für im aktiven Bereich erzeugte Strahlung einen höheren Transmissionskoeffizienten, vorzugsweise eine höhere Transmission auf. Die aus dem Halbleiterchip auskoppelbare und die Kontaktschicht durchstrahlende Strahlungsleistung ist in der Folge erhöht.

Ferner kann die strahlungsdurchlässige und elektrisch leitfähige Kontaktschicht verglichen mit einer metallischen Kontaktschicht vereinfacht zur Stromaufweitung genutzt werden. Strom kann in der Kontaktschicht über eine laterale Haupterstreckungsrichtung des Halbleiterkörpers homogen verteilt und besonders gleichmäßig in den Halbleiterkörper eingeprägt werden, da es nicht notwendig ist, Öffnungen für den Strahlungsdurchtritt in der Kontaktschicht vorzusehen. Die Kontaktschicht kann insbesondere als aussparungsfreie, also als unterbrechungsfreie und durchgehende, Schicht ausgeführt sein.

Während über den Anschlussbereich der Anschlussschicht Ladungsträger zum aktiven Bereich hin injiziert werden können, ist die Barriereschicht vorzugsweise derart ausgebildet, dass eine Ladungsträgerinjektion mittels der Kontaktschicht zum aktiven Bereich über die Barriereschicht gegenüber einer Injektion von Ladungsträger über die Anschlussschicht mittels der Kontaktschicht verringert ist.

Die Kontaktschicht grenzt bevorzugt in einem Barrierebereich an die Barriereschicht und/oder in dem Anschlussbereich an die Anschlussschicht an. Insbesondere können die Barriereschicht und die Anschlussschicht den Halbleiterkörper auf der der Kontaktschicht zugewandten Seite begrenzen. Der Barrierebereich ist vorzugsweise durch den direkten Kontaktbereich der Kontaktschicht mit der Barriereschicht gebildet. Der Anschlussbereich ist vorzugsweise durch den direkten Kontaktbereich der Kontaktschicht mit der Anschlussschicht gebildet.

Bei dem erfindungsgemäßen Halbleiterchip kann somit über den Anschlussbereich bereichsweise Strom in den Halbleiterkörper injiziert werden, während eine Ladungsträgerinjektion über den Barrierebereich gegenüber der Injektion über den Anschlussbereich stark verringert ist.

Mittels einer Kontaktstruktur, die die Kontaktschicht, die Anschlussschicht und die Barriereschicht umfasst, kann somit eine gezielte, bereichsweise Ladungsträgerinjektion in den Halbleiterkörper in vorgegebenen Bereichen erzielt werden. Diese Bereiche sind alleine mittels des Barrierebereichs der Barriereschicht und des Anschlussbereichs der Anschlussschicht definierbar, die zweckmäßigerweise unterschiedliche elektrische Kontakteigenschaften zur Kontaktschicht aufweisen. Auf zusätzliche Maßnahmen zur Definition eines Anschlussbereichs wie eine zwischen dem Halbleiterkörper und der Kontaktschicht angeordnete und zur elektrischen Kontaktbildung zum Halbleiterkörper bereichsweise geöffnete elektrisch isolierende Schicht, z.B. eine Siliziumnitrid-Schicht, die also nicht Teil des Halbleiterkörpers ist, kann mit Vorteil verzichtet werden.

Es sei angemerkt, dass auch schon eine Kontaktstruktur mit einer Kontaktschicht, die zu einem Halbleiterkörper sowohl einen Barrierebereich als auch einen Anschlussbereich ausbildet, eine Möglichkeit darstellt.

In einer bevorzugten Ausgestaltung sind die Barriereschicht und die Anschlussschicht derart ausgebildet, dass eine Barriere für eine Ladungsträgerinjektion mittels der Kontaktschicht über die Barriereschicht in den Halbleiterkörper größer ist als die Barriere für eine Ladungsträgerinjektion mittels der Kontaktschicht über die Anschlussschicht in den Halbleiterkörper. Insbesondere sind die Barriereschicht und die Anschlussschicht bezüglich einer Kontaktschicht aus einem vorgegebenen Material oder einer vorgegebenen Materialzusammensetzung zweckmäßigerweise derart ausgebildet. Erfindungsgemäß ist hierbei ein elektrischer Kontaktwiderstand der Kontaktschicht zur Anschlussschicht kleiner als ein elektrischer Kontaktwiderstand der Kontaktschicht zur Barriereschicht. Eine Ladungsträgerinjektion in den Halbleiterkörper über die Barriereschicht kann somit besonders effizient vermindert werden, während die Ladungsträgerinjektion über die Anschlussschicht zugleich entsprechend erhöht wird.

In einer weiteren bevorzugten Ausgestaltung sind die Anschlussschicht und die Barriereschicht verschieden, insbesondere als separate Schichten der Halbleiterschichtenfolge, ausgeführt. Unterschiedliche elektrische Kontakteigenschaften der Anschluss- und der Barriereschicht zur Kontaktschicht können so vereinfacht erzielt werden. Die Anschlussschicht und die Barriereschicht können eine unterschiedliche Zusammensetzung aufweisen. Bevorzugt enthalten die Anschlussschicht und die Barriereschicht verschiedene Halbleitermaterialien, insbesondere verschiedene III-V-Halbleitermaterialien, oder basieren auf verschiedenen Materialien. Besonders bevorzugt enthalten die Anschlussschicht und die Barriereschicht Halbleitermaterialien aus verschiedenen Halbleitermaterialsystemen, insbesondere verschiedenen III-V-Halbleitermaterialsystemen, oder basieren auf verschiedenen Materialsystemen.

III-V-Verbindungshalbleitermaterialien, wie Nitrid-Verbindungshalbleiter, Phosphid-Verbindungshalbleiter oder Arsenid-Verbindungshalbleiter, sind zur Ausbildung einer Halbleiterschichtenfolge für den Halbleiterkörper eines effizienten Halbleiterchips, insbesondere zur Ausbildung eines aktiven Bereichs mit hoher Quanteneffizienz besonders geeignet.

Basieren die Anschlussschicht und die Barriereschicht auf verschiedenen der zuvor genannten III-V-Halbleitermaterialsysteme, so basiert die Anschlussschicht vorzugsweise auf einem Phosphid-Verbindungshalbleitermaterial und die Barriereschicht auf einem Arsenid-Verbindungshalbleitermaterial, oder umgekehrt. Halbleiterschichten, die auf Materialien aus diesen Materialsystemen basieren, können auf einem gemeinsamen Aufwachssubstrat und insbesondere aufeinander gewachsen werden.

Im Zweifel bedeutet "basiert auf Nitrid-Verbindungshalbleitermaterial", dass zumindest ein Teil der Halbleiterschichtenfolge ein Nitrid/V-Verbindungshalbleitermaterial umfasst, vorzugsweise $Al_nGa_mIn_{1-n-m}N$, wobei $0 \leq n \leq 1$, $0 \leq m \leq 1$ und $n+m \leq 1$, insbesondere mit $m \neq 0$ und/oder $n \neq 0$. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des $Al_nGa_mIn_{1-n-m}N$-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Entsprechend bedeutet vorliegend "basiert auf Phosphid-Verbindungshalbleitermaterial" im Zweifel, dass zumindest ein Teil der Halbleiterschichtenfolge ein Phosphid/V-Verbindungshalbleitermaterial umfasst, vorzugsweise $Al_nGa_mIn_{1-n-m}P$, wobei $0 \leq n \leq 1$, $0 \leq m \leq 1$ und $n+m \leq 1$, insbesondere mit $m \neq 0$ und/oder $n \neq 0$. Dabei muss auch dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des $Al_nGa_mIn_{1-n-m}P$-Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Ebenfalls entsprechend bedeutet vorliegend "basiert auf Arsenid-Verbindungshalbleitermaterial" im Zweifel, dass zumindest ein Teil der Halbleiterschichtenfolge ein Arsenid/V-Verbindungshalbleitermaterial umfasst, vorzugsweise $Al_nGa_mIn_{1-n-m}As$, wobei $0 \leq n \leq 1$, $0 \leq m \leq 1$ und $n+m \leq 1$, insbesondere mit $m \neq 0$ und/oder $n \neq 0$. Auch dieses Material muss nicht zwingend eine mathematisch exakte Zusammensetzung nach obiger Formel aufweisen und kann ein oder mehrere Dotierstoffe sowie zusätzliche Bestandteile aufweisen, die die cha-

rakteristischen physikalischen Eigenschaften des $Al_nGa_mIn_{1-n-m}As$-Materials im Wesentlichen nicht ändern. Wiederum beinhaltet obige Formel der Einfachheit halber jedoch nur die wesentlichen Bestandteile des Kristallgitters (Al, Ga, In, As), auch wenn diese teilweise durch geringe Mengen weiterer Stoffe ersetzt sein können.

Nitrid-Verbindungshalbleitermaterial eignet sich besonders für einen aktiven Bereich zur Erzeugung ultravioletter bis blauer Strahlung, Phosphid-Verbindungshalbleitermaterial besonders für einen aktiven Bereich zur Erzeugung gelber bis roter Strahlung und Arsenid-Verbindungshalbleitermaterial besonders zur Erzeugung infraroter Strahlung. Bevorzugt ist der Halbleiterchip zur Erzeugung sichtbaren Lichts ausgebildet.

Die Anschlussschicht basiert beispielsweise auf einem Arsenid-Verbindungshalbleitermaterial und die Barriereschicht beispielsweise auf einem Phosphid-Verbindungshalbleitermaterial. Diese Verbindungshalbleitermaterialien können vereinfacht in einer gemeinsamen Halbleiterschichtenfolge monolithisch integriert werden.

Die Anschlussschicht und die Barriereschicht können nicht nur über verschiedene Zusammensetzungen, sondern alternativ oder ergänzend auch durch andere Maßnahmen mit unterschiedlichen elektrischen Kontakteigenschaften zur Kontaktschicht ausgebildet werden. Im Besonderen können die Anschlussschicht und die Barriereschicht auf dem gleichen Materialsystem basieren oder sogar die gleiche Materialzusammensetzung aufweisen. Geeignete Maßnahmen für die Ausbildung unterschiedlicher Kontakteigenschaften werden weiter unten näher erläutert.

In einer weiteren nicht erfindungsgemäßen Ausgestaltung ist die Anschlussschicht zwischen dem aktiven Bereich und der Barriereschicht, insbesondere zwischen dem Barrierebereich und dem aktiven Bereich angeordnet. Zweckmäßigerweise weist die Barriereschicht hierbei eine Aussparung auf, die diese Schicht vorzugsweise vollständig durchdringt. Die Kontaktschicht kann sich durch die Aussparung erstrecken. Ein elektrischer und insbesondere auch ein direkter Kontakt der Kontaktschicht zur Anschlussschicht kann durch die Aussparung hindurch hergestellt sein. Der Anschlussbereich kann die Aussparung der Barriereschicht begrenzen.

In einer weiteren bevorzugten Ausgestaltung ist die Barriereschicht zwischen dem aktiven Bereich und der Anschlussschicht, insbesondere zwischen dem Anschlussbereich und dem aktiven Bereich angeordnet. Zweckmäßigerweise weist die Anschlussschicht hierbei eine Aussparung auf, durch die sich die Kontaktschicht erstreckt. Das Ausbilden eines Barrierebereichs zwischen der Kontaktschicht und der Barriereschicht wird so erleichtert. Der Barrierebereich kann die Aussparung der Anschlussschicht begrenzen.

Die jeweilige nicht ausgesparte Schicht - die Anschluss- bzw. die Barriereschicht - kann als durchgehende, also aussparungsfreie, Schicht ausgeführt sein. Erfindungsgemäß ist die Barriereschicht zwischen der Kontaktschicht und der Anschlussschicht angeordnet. In einer weiteren bevorzugten Ausgestaltung ist die Kontaktschicht als aussparungsfreie Schicht ausgeführt. Die Kontaktschicht kann vollflächig an den Halbleiterkörper angrenzen. Bevorzugt grenzt die Kontaktschicht vollflächig an die Barriereschicht und die Anschlussschicht an.

In einer weiteren bevorzugten Ausgestaltung sind die Anschlussschicht und die Barriereschicht monolithisch in die Halbleiterschichtenfolge integriert. Die Halbleiterschichtenfolge mit dem aktiven Bereich, der Anschluss- und der Barriereschicht kann also in einem durchgehenden Prozess gefertigt sein. Beispielsweise kann die Halbleiterschichtenfolge mit der Anschlussschicht und der Barriereschicht epitaktisch auf einem Aufwachssubstrat gewachsen sein. Die Anschlussschicht und die Barriereschicht können demnach insbesondere epitaktisch gewachsen sein.

Die Anschlussschicht und die Barriereschicht können weiterhin aneinander angrenzen.

Die Kontaktschicht ist bevorzugt auf den vorgefertigten Halbleiterkörper aufgebracht. Hierzu wird besonders bevorzugt ein vom Herstellungsverfahren der Halbleiterschichtenfolge verschiedenes Verfahren eingesetzt. Zum Aufbringen der Kontaktschicht eignet sich besonders ein Abscheideverfahren.

In einer weiteren bevorzugten Ausgestaltung weisen die Barriereschicht und die Anschlussschicht verschiedene Leitungstypen (n-leitend bzw. p-leitend) auf. Schichten mit unterschiedlichen Leitungstypen können sich erheblich bezüglich der elektrischen Kontakteigenschaften zur Kontaktschicht unterscheiden, so dass das Ausbilden der Barriereschicht und der Anschlussschicht auf diese Weise erleichtert wird.

Beispielsweise können die Barriereschicht und eine auf der von der Barriereschicht abgewandten Seite des aktiven Bereichs angeordnete Halbleiterschicht der Halbleiterschichtenfolge den gleichen Leitungstypen aufweisen, z.B. n-leitend.

Bei einer derartigen Ausbildung mit unterschiedlichen Leitungstypen ist die Barriereschicht bevorzugt auf der der Kontaktschicht zugewandten Seite der Anschlussschicht angeordnet. Andernfalls müssten über die Anschlussschicht injizierte Ladungsträger gegebenenfalls einen mittels der Barriereschicht im Halbleiterkörper ausgebildeten pn-Übergang überwinden, um zum aktiven Bereich gelangen zu können. Eine derartige Barriere für Ladungsträger im Halbleiterkörper zwischen der Anschlussschicht und dem aktiven Bereich kann durch Anordnung der Barriereschicht auf der dem aktiven Bereich abgewandten Seite der Anschlussschicht vermieden werden.

In einer weiteren bevorzugten Ausgestaltung ist die Anschlussschicht dotiert ausgeführt und die Barriereschicht ist undotiert ausgeführt. Auch hierüber können unterschiedliche Kontakteigenschaften der Anschluss- und der Barriereschicht zur Kontaktschicht erzielt werden. Hierbei kann die Barriereschicht zwischen der Anschlussschicht und der Kontaktschicht angeordnet sein. Da undotierte Schichten in der Regel eine vergleichsweise geringe Leitfähigkeit aufweisen, ist eine Anordnung der Barriereschicht zwischen der Kontaktschicht und der Anschlussschicht aufgrund einer verbesserten Zuleitung von Ladungsträgern im Halbleiterkörper zum aktiven Bereich besonders zweckmäßig. Da zum Ausbilden einer Barriere bereits eine vergleichsweise dünne Schicht mit vergleichsweise geringem Widerstandsbeitrag zum elektrischen Widerstand im Halbleiterkörper genügen kann, ist letztere Anordnung aber nicht unbedingt erforderlich.

In einer weiteren bevorzugten Ausgestaltung weisen die Anschlussschicht und die Barriereschicht den gleichen Leitungstypen auf. Eine Dotierstoffkonzentration der Anschlussschicht ist hierbei bevorzugt, insbesondere im Anschlussbereich, größer als eine Dotierstoffkonzentration der Barriereschicht. Auch hierüber kann der Kontaktwiderstand der Kontaktschicht zur Barriereschicht gegenüber dem Kontaktwiderstand zur Anschlussschicht erhöht werden. Da die Dotierstoffkonzentration einen erheblich höheren Einfluss auf die elektrische Kontaktbildung der Kontaktschicht zum Halbleiterkörper als auf den elektrischen Widerstand im Volumen des Halbleiterkörpers haben kann, kann hierbei die Barriereschicht zwischen der Anschlussschicht und der Kontaktschicht angeordnet sein. Eine Anordnung der Barriereschicht zwischen der Anschluss- und der Kontaktschicht ist auch in diesem Falle besonders zweckmäßig.

In einer weiteren bevorzugten Ausgestaltung beträgt eine Dotierstoffkonzentration der Anschlussschicht $5*10^{15}$ $1/(cm^3)$ oder mehr. Eine Dotierstoffkonzentration von $1 * 10^{16}$ $1/(cm^3)$ und insbesondere von $1 * 10^{17}$ $1/(cm^3)$ oder mehr hat sich für die Anschlussschicht als besonders vorteilhaft erwiesen. Insbesondere ist dies im Hinblick auf die Ausbildung eines ohmschen Kontaktes zwischen der Kontaktschicht und der Anschlussschicht von besonderem Vorteil, da das Ausbilden eines ohmschen barrierearmen Kontakts mit höheren Dotierstoffkonzentrationen vereinfacht erzielt werden kann.

In einer weiteren bevorzugten Ausgestaltung ist die Anschlussschicht p-leitend ausgeführt.

In einer weiteren bevorzugten Ausgestaltung sind die Anschlussschicht und die Barriereschicht frei von die Leitfähigkeiten oder die Kontakteigenschaften der Schichten zur Kontaktschicht beeinflussenden Modifikationen. Insbesondere sind diese Schichten abgesehen von der Dotierung beziehungsweise intrinsischen Ausführung der jeweiligen Schicht und/oder unterschiedlicher Zusammensetzung der Schichten bevorzugt modifikationsfrei. Die Schichten können also bereits mit den jeweiligen Kontakteigenschaften hergestellt, z.B. gewachsen sein. Auf nachfolgende Maßnahmen, wie etwa Oxidation oder Implantation, z.B. Protonenimplantation, zur Definition von Bereichen mit hohen Barrieren für die Ladungsträgerinjektion kann mit Vorteil verzichtet werden.

Die Schichten - Anschluss- und/oder Barriereschicht - können jeweils über ihren gesamten lateralen Verlauf eine im Wesentlichen in lateraler Richtung konstante Leitfähigkeit aufweisen.

In einer weiteren bevorzugten Ausgestaltung ist der Halbleiterkörper als Dünnfilm-Halbleiterkörper ausgeführt.

Als Dünnfilm-Halbleiterkörper kann im Rahmen der vorliegenden Anmeldung ein Halbleiterkörper angesehen werden, bei dem das Herstellungssubstrat, auf dem die Halbleiterschichtenfolge des Halbleiterkörpers hergestellt ist, gedünnt, bereichsweise von der Halbleiterschichtenfolge entfernt oder vollständig von der Halbleiterschichtenfolge entfernt ist. Das Herstellungssubstrat kann mittels eines Substrats, auf dem die Halbleiterschichtenfolge abgeschieden ist, gebildet sein. Zum Beispiel kann das Herstellungssubstrat durch das Aufwachssubstrat, auf dem die Halbleiterschichtenfolge epitaktisch gewachsen ist, gebildet sein.

In einer bevorzugten Ausgestaltung umfasst der Halbleiterchip einen Träger, auf dem die Halbleiterschichtenfolge angeordnet ist, und die Kontaktschicht ist zwischen der Halbleiterschichtenfolge und dem Träger angeordnet. Der Träger ist vorzugsweise vom Herstellungssubstrat der Halbleiterschichtenfolge verschieden. Der Träger kann die Halbleiterschichtenfolge mechanisch stabilisieren. Besonders zweckmäßig ist es, einen derartigen Träger bei einer Ausbildung des Halbleiterchips mit einem Dünnfilm-Halbleiterkörper einzusetzen, da bei einem Dünnfilm-Halbleiterkörper die stabilisierende Wirkung des Herstellungssubstrats zumindest verringert ist oder vollständig entfällt.

Da der Träger des Dünnfilm-Halbleiterkörpers vom Herstellungssubstrat verschieden ist, kann er vergleichsweise frei gewählt werden, ohne die für die Herstellung der Halbleiterschichtenfolge erforderlichen Eigenschaften, z.B. hinsichtlich der Kristallstruktur, etwa der Gitterkonstante, aufweisen zu müssen. Beispielsweise kann der Träger hinsichtlich thermischer oder elektrischer Leitfähigkeit optimiert gewählt werden. Die Effizienz des Halbleiterchips kann so gesteigert werden.

Die Kontaktstruktur mit der Anschlussschicht, der Barriereschicht und der Kontaktschicht kann insbesondere als vergrabene Kontaktstruktur ausgeführt sein, über die der Halbleiterkörper trägerseitig elektrisch kontaktiert werden kann.

Die Halbleiterschichtenfolge wird für den Dünnfilm-Halbleiterkörper bevorzugt vor dem Dünnen, dem bereichsweisen oder dem vollständigen Entfernen des Substrats auf dem Träger angeordnet, so dass der Träger die Halbleiterschichtenfolge mechanisch stabilisiert. Die Gefahr einer Schädigung der Halbleiterschichtenfolge wegen ungenügender mechanischer Stabilisierung bei der Behandlung des Substrats wird so verringert.

Der Träger wird besonders bevorzugt auf der dem Herstellungssubstrat abgewandten Seite der Halbleiterschichtenfolge angeordnet. Weitergehend kann auch ein Zwischenträger derart angeordnet werden und der Träger nach dem Entfernen des Herstellungssubstrats auf die dem Zwischenträger abgewandte Seite der Halbleiterschichtenfolge, also der Seite auf der das Herstellungssubstrat angeordnet war, aufgebracht werden. Der Zwischenträger kann nachfolgend entfernt werden. Erfindungsgemäß ist auf der von dem aktiven Bereich abgewandten Seite der Kontaktschicht eine Spiegelschicht angeordnet. Bevorzugt ist die Spiegelschicht elektrisch leitfähig ausgebildet und besonders bevorzugt ist die Spiegelschicht elektrisch leitend mit der Kontaktschicht verbunden.

Die Spiegelschicht ist zweckmäßigerweise für die im aktiven Bereich erzeugte Strahlung reflektierend ausgeführt. Mittels der Spiegelschicht kann durch die strahlungsdurchlässige Kontaktschicht tretende und auf die Spiegelschicht treffende Strahlung wieder in den Halbleiterkörper zurückreflektiert werden. Die über die von der Spiegelschicht abgewandte Seite des Halbleiterkörpers aus dem Halbleiterchip auskoppelnde Strahlungsleistung kann so erhöht werden.

Die der Spiegelschicht abgewandte Seite des Halbleiterkörpers bildet bevorzugt die Oberseite des oberflächenstrahlenden Halbleiterchips. Die Spiegelschicht ist vorzugsweise auf der einer Montageseite zur Montage des Halbleiterchips auf einem externen Anschlussleiter zugewandten Seite des Halbleiterkörpers angeordnet.

Die Spiegelschicht ist ferner vorzugsweise als aussparungsfreie Schicht ausgeführt.

Weiterhin grenzt die Spiegelschicht bevorzugt an die Kontaktschicht an. Die Spiegelschicht kann vollflächig an die Kontaktschicht angrenzen.

Mittels einer elektrisch leitfähigen Spiegelschicht und der Kontaktschicht kann eine reflektierende Kontaktstruktur mit einem bereichsweisen elektrischen Anschluss an den Halbleiterkörper auf besonders einfache Weise ausgebildet werden. Erfindungsgemäß enthält die Spiegelschicht ein Metall. Eine metallhaltige Spiegelschicht zeichnet sich durch eine vorteilhaft geringe Abhängigkeit der Reflektivität vom Einfallswinkel der Strahlung auf die Spiegelschicht aus. Insbesondere unter vergleichsweise großen Winkeln zur Oberflächennormalen der Spiegelschicht auf diese treffende Strahlung kann so zuverlässig reflektiert werden.

Bevorzugt ist die Spiegelschicht metallisch ausgeführt oder enthält eine Legierung, die mindestens ein Metall enthält. Geeignete Metalle sind z.B. Au, Al oder Ag, geeignete Legierungen, die bevorzugt mindestens eines der zuvor genannten Metalle enthalten, sind z.B. AuGe oder AuZn. Eine metallhaltige Spiegelschicht kann auf den Dünnfilm-Halbleiterkörper, beispielsweise mittels Aufdampfen, aufgebracht sein.

Mittels einer durchgehend zwischen der Spiegelschicht und dem Halbleiterkörper angeordneten Kontaktschicht kann weiterhin ein direkter Kontakt des Halbleiterkörpers mit der Spiegelschicht vermieden werden. In einem derartigen Kontaktbereich zwischen Spiegelschicht und Halbleiterkörper können Bereiche geringerer Reflektivität ausgebildet werden, da sich im Kontaktbereich eine Legierung mit einem metallischen Material der Spiegelschicht bilden kann. Diese Legierung kann eine geringere Reflektivität als der verbleibende Bereich der Spiegelschicht aufweisen. Dies kann im Rahmen der Erfindung vermieden werden.

Ein Dünnfilm-Halbleiterchip, d.h. ein Halbleiterchip mit Dünnfilm-Halbleiterkörper und Träger, kann sich weiterhin durch zumindest eines der folgenden Merkmale auszeichnen:

- an einer zu dem Träger hin gewandten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20pm oder weniger, insbesondere im Bereich von 10 $\mu$m auf; und/oder
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist

ein möglichst ergodisch stochastisches Streuverhalten auf. Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben. Zur Befestigung des Halbleiterkörpers auf dem Träger für einen Dünnfilm-Halbleiterchip kann zwischen der Kontaktschicht und dem Träger eine Verbindungsschicht angeordnet und/oder ausgebildet sein. Die Spiegelschicht ist bevorzugt zwischen der Verbindungsschicht und der Kontaktschicht angeordnet.

In einer weiteren bevorzugten Ausgestaltung überdeckt der Barrierebereich eine auf der von dem Barrierebereich abgewandten Seite des Halbleiterkörpers angeordnete Elektrode des Halbleiterchips. Die Elektrode kann insbesondere als Elektrodenmetallisierung ausgeführt sein. Weiterhin kann die Elektrode für eine Drahtbondung vorgesehen sein. Derartige Elektroden sind für die im aktiven Bereich erzeugte Strahlung in der Regel absorbierend. Da über den Barrierebereich nicht oder nur in stark verringertem Maße Ladungsträger in den Halbleiterkörper injiziert werden, wird im von der Elektrode in lateraler Richtung überdeckten Bereich des aktiven Bereichs nur eine vergleichsweise geringe Strahlungsleistung erzeugt. Auf diese Weise kann die in der Elektrode absorbierbare Strahlungsleistung vermindert werden, da die unterhalb der Elektrode erzeugte Strahlungsleistung aufgrund der Anordnung des Barrierebereichs verringert ist. Die Effizienz des Halbleiterchips, insbesondere die aus dem Chip auskoppelbare Strahlungsleistung wird in der Folge erhöht.

In einer weiteren bevorzugten Ausgestaltung ist der Barrierebereich in einem Randbereich des Halbleiterchips, insbesondere einem Randbereich des Halbleiterkörpers angeordnet. Im Randbereich des aktiven Bereichs, den der Barrierebereich in diesem Falle bevorzugt überdeckt, ist der Anteil an nichtstrahlend rekombinierenden Ladungsträgern oftmals besonders hoch. Die Quanteneffizienz des Halbleiterchips kann durch eine derartige Anordnung des Barrierebereichs erhöht werden.

In einer weiteren bevorzugten Ausgestaltung weist der Halbleiterchip eine Mehrzahl von Barrierebereichen auf, wobei einer dieser Barrierebereiche die auf der von dem Barrierebereich abgewandten Seite des Halbleiterkörpers angeordnete Elektrode des Halbleiterchips überdeckt und ein anderer Barrierebereich im Randbereich des Chips angeordnet ist. Diese Barrierebereiche können als zusammenhängender Bereich oder als separate Bereiche ausgebildet sein. Im ersten Fall können, im Gegensatz zum zweiten Fall, zwei beliebige Punkte des Barrierebereichs miteinander verbunden werden, ohne den Barrierebereich zu verlassen.

In einer weiteren bevorzugten Ausgestaltung umfasst der Halbleiterchip eine Mehrzahl von Anschlussbereichen. Die Anschlussbereiche können als zusammenhängender Bereich oder als separate Bereiche ausgebildet sein. Über die Mehrzahl von Anschlussbereichen kann die Strahlungserzeugung auf Zonen des aktiven Bereichs konzentriert werden, die für die Strahlungsauskopplung aus dem Halbleiterchip besonders günstig ist. In diesem Sinne geeignet sind zum Beispiel Zonen, die nicht von der Elektrode oder einer Elektrodenstruktur auf der der Kontaktschicht abgewandten Seite des Halbleiterkörpers überdeckt sind.

In einer weiteren bevorzugten Ausgestaltung enthält die Kontaktschicht ein strahlungsdurchlässiges und elektrisch leitfähiges Oxid (TCO: Transparent Conductive Oxide), insbesondere ein Metalloxid, beispielsweise ein Zinkoxid, wie ZnO, ein Indiumzinnoxid (ITO: Indium Tin Oxide), oder ein Zinnoxid, wie $SnO_2$. Strahlungsdurchlässige und elektrisch leitfähige Oxide zeichnen sich durch hohe Strahlungsdurchlässigkeit bei gleichzeitig hoher Leitfähigkeit, insbesondere in lateraler Richtung, aus. Zur elektrischen Kontaktbildung zu p-leitenden Halbleitermaterialien ist ZnO oder ein ITO besonders geeignet. Zur Kontaktbildung zu n-leitenden Halbleitermaterialien ist $SnO_2$ besonders geeignet.

Eine TCO-haltige Kontaktschicht kann dotiert sein, wodurch die Leitfähigkeit erhöht werden kann. Hierfür eignet sich zum Beispiel Al für ZnO oder Sb für $SnO_2$.

Strahlungsdurchlässige und elektrisch leitfähige Oxide können sich ferner durch vorteilhaft hohe thermische Leitfähigkeiten auszeichnen. Thermische Leitfähigkeiten von dielektrischen Schichten, z.B. aus SiN, die zur Kontaktbildung einer Kontaktschicht zum Halbleiterkörper ausgespart sind, sind demgegenüber in der Regel geringer. Der thermische Widerstand für aus dem Halbleiterkörper abzuführende Wärme kann so vermindert werden. In der Folge kann die Gefahr einer thermisch bedingten Schädigung des Halbleiterchips verringert werden.

Zur elektrischen Kontaktbildung zum Halbleiterkörper alleine ist eine vergleichsweise dünne strahlungsdurchlässige Kontaktschicht bereits ausreichend. Die Kontaktschicht kann beispielsweise eine Dicke von 200 nm oder weniger aufweisen. Weist die Kontaktschicht über ihren lateralen Verlauf eine sich verändernde Dicke auf, so kann für die Dicke der Kontaktschicht gegebenenfalls die minimale Dicke herangezogen werden.

Bevorzugt weist die strahlungsdurchlässige Kontaktschicht eine Dicke auf, die größer oder gleich einer viertel Wellenlänge der im aktiven Bereich erzeugten Strahlung in der Kontaktschicht ist. Mathematisch ausgedrückt erfüllt die Dicke D der Kontaktschicht, insbesondere die minimale Dicke vorzugsweise die Beziehung:

$$D \geq \frac{\lambda}{4n_k} + m \cdot \frac{\lambda}{2n_k}$$

wobei $\lambda$ eine charakteristische Emissionswellenlänge, etwa die Peakwellenlänge, die Dominantwellenlänge oder eine Schwerpunktswellenlänge des Emissionsspektrums der im aktiven Bereich erzeugten Strahlung, $n_k$ der Brechungsindex der Kontaktschicht und m = 0,1,2, ... ist.

Weiterhin ist die Dicke D bevorzugt tatsächlich größer als die rechte Seite der Ungleichung, also ungleich der rechten Seite. Hierdurch kann die Gesamt-Reflektivität der reflektierenden Kontaktstruktur mit der Spiegelschicht und der Kontaktschicht unter Berücksichtigung von schrägem Strahlungseinfall vorteilhaft erhöht werden. Eine Dickenänderung um ganzzahlige Vielfache

von $\dfrac{\lambda}{2n_k}$ ändert die Reflexionseigenschaften der Kontaktstruktur nicht maßgeblich. Daher ist bevorzugt m=0. Die Kontaktschicht kann so besonders materialsparend ausgebildet werden.

In einer weiteren bevorzugten Ausgestaltung enthält die Anschlussschicht GaAs oder AlGaAs, vorzugsweise mit einem niedrigen Al-Gehalt. GaAs oder AlGaAs, insbesondere mit einem niedrigen Al-Gehalt, z.B. von 40% oder weniger, ist für die elektrische Kontaktbildung zu TCO-Materialien, insbesondere zu ZnO, besonders geeignet.

Mittels einer Kontaktschicht, die ZnO enthält, und einer Spiegelschicht, die Au enthält, kann ein besonders effizienter und einfach herstellbarer Halbleiterchip, insbesondere mit einem aktiven Bereich, der ein Phosphid-Verbindungshalbleitermaterial enthält, ausgebildet werden.

In einer weiteren bevorzugten Ausgestaltung ist der Halbleiterchip als Lumineszenzdiodenchip, etwa als LED-Chip zur Erzeugung inkohärenter Strahlung, z.B. als LED-Chip ohne Resonator oder als RCLED-Chip (Resonant Cavity Light Emitting Diode) mit Resonator, oder als Laserdiodenchip zur Erzeugung kohärenter Strahlung, z.B. für einen kantenemittierenden Laser, einen vertikalemittierenden Laser mit internem Resonator (VCSEL: Vertical Cavity Surface Emitting Laser) oder einen vertikalemittierenden Laser mit externem Resonator (VECSEL: Vertical External Cavity Surface Emitting Laser), ausgebildet.

In einem Verfahren zur Herstellung einer Kontaktstruktur für einen zur Strahlungserzeugung geeigneten optoelektronischen Halbleiterchip wird zunächst eine Halbleiterschichtenfolge mit einer Anschlussschicht und einer Barriereschicht bereitgestellt, wobei die Barriereschicht auf der Anschlussschicht angeordnet ist.

Nachfolgend kann in einer ersten Variante die Anschlussschicht bereichsweise entfernt werden, wobei die Barriereschicht freigelegt wird. Komplementär hierzu kann in einer zweiten Variante die Barriereschicht unter Freilegung der Anschlussschicht bereichsweise entfernt werden. Für die erste Variante ist zweckmäßigerweise eine Halbleiterschichtenfolge vorgesehen, bei der die Barriereschicht zwischen der Anschlussschicht und dem aktiven Bereich der Halbleiterschichtenfolge angeordnet ist. Für die zweite nicht erfindungsgemäße Variante ist die Anschlussschicht zweckmäßigerweise zwischen der Barriereschicht und dem aktiven Bereich angeordnet. Daraufhin wird eine strahlungsdurchlässige und elektrisch leitfähige Kontaktschicht auf die Halbleiterschichtenfolge aufgebracht, wobei die Kontaktschicht sowohl, insbesondere unmittelbar, auf der Anschlussschicht als auch, insbesondere unmittelbar, auf der Barriereschicht angeordnet ist. Ein elektrischer Kontaktwiderstand der Barriereschicht zur Kontaktschicht ist vorzugsweise größer als der elektrische Kontaktwiderstand der Kontaktschicht zur Anschlussschicht.

Die Kontaktschicht kann auf der Halbleiterschichtenfolge, insbesondere mittels eines Vakuumprozesses, abgeschieden werden. Beispielsweise kann die Kontaktschicht mittels eines PVD-Verfahrens (Physical Vapor Deposition), wie Sputter oder Aufdampfen, oder eines CVD-Verfahrens (Chemical Vapor Deposition), wie PECVD (Plasma Enhanced Chemical Vapor Deposition), abgeschieden werden.

Um eine elektrische Kontaktbildung der Kontaktschicht zur Anschlussschicht zu fördern, kann nach dem Aufbringen der Kontaktschicht ein Temperaturprozess, z.B. ein Sinterprozess, durchgeführt werden.

Die Kontaktschicht kann ferner vollflächig auf die Halbleiterschichtenfolge aufgebracht werden. Weiterhin kann die Kontaktschicht als unstrukturierte, d.h. nach dem Aufbringen, z.B. als durchgehende Schicht, nicht weitergehend strukturierte, Schicht ausgeführt sein. Auf das Vorsehen einer elektrisch isolierenden strukturierten Schicht, z.B. einer Siliziumnitridschicht, kann aufgrund der Ausbildung der Anschlussschicht und der Barriereschicht mit verschiedenen elektrischen Kontakteigenschaften zur Kontaktschicht verzichtet werden. Somit kann das Aufbringen der isolierenden Schicht und ein Strukturierungsschritt, z.B. ein

Photolithographieschritt, für die isolierende Schicht eingespart werden.

In einer bevorzugten Ausgestaltung des Verfahrens wird auf der der Halbleiterschichtenfolge abgewandten Seite der Kontaktschicht eine, insbesondere elektrisch leitfähige Spiegelschicht aufgebracht. Vorzugsweise wird die Spiegelschicht abgeschieden, z.B. aufgedampft oder aufgesputtert. Weiterhin wird die Spiegelschicht mit Vorzug als durchgehende Schicht, insbesondere vollflächig, aufgebracht. Die Spiegelschicht kann in einem Vakuumprozess aufgebracht werden.

Der Schichtverbund mit der Kontaktschicht, der Anschluss- und der Barriereschicht sowie gegebenenfalls der Spiegelschicht kann nachfolgend auf einem Träger für den Halbleiterchip angeordnet werden. Die Kontaktschicht ist hierbei zweckmäßigerweise zwischen dem Träger und der Halbleiterschichtenfolge angeordnet. Der Träger ist vorzugsweise Teil des Halbleiterchips, für den die Kontaktstruktur vorgesehen ist.

Ein Substrat, auf dem die Halbleiterschichtenfolge beim Bereitstellen vorzugsweise angeordnet ist, z.B. das Herstellungssubstrat der Halbleiterschichtenfolge, kann nach der Anordnung des Schichtverbunds auf dem Träger gedünnt, bereichsweise oder vollständig entfernt werden. Zweckmäßigerweise wird die Kontaktschicht in diesem Falle auf die dem Substrat abgewandte Seite des Halbleiterkörpers aufgebracht.

Vorzugsweise wird das Verfahren bei der Herstellung eines erfindungsgemäßen Halbleiterchips durchgeführt. Oben und im Folgenden für den Halbleiterchip näher beschriebene Merkmale können sich demnach auch auf das Verfahren zur Herstellung der Kontaktstruktur oder zur Herstellung eines Halbleiterchips mit einer entsprechenden Kontaktstruktur beziehen und umgekehrt.

Vorteilhafte Ausgestaltungen und Weiterbildungen der Erfindung ergeben sich aus der folgenden Beschreibung der Ausführungsbeispiele in Verbindung mit den Figuren. Dabei bezeichnet im folgenden der Begriff "Ausführungsbeispiel" nur dann Ausführungsbeispiele der vorliegenden Erfindung, wenn diese jeweils alle im Anspruch 1 definierten Merkmale enthalten. Ansonsten bezeichnet dieser Begriff lediglich andere Beispiele, die für das Verstehen der vorliegenden in Anspruch 1 definierten Erfindung hilfreich sind.

Figur 1 zeigt eine schematische Schnittansicht eines ersten Ausführungsbeispiels eines nicht erfindungsgemäßen optoelektronischen Halbleiterchips,
Figur 2 zeigt eine schematische Schnittansicht eines weiteren Ausführungsbeispiels eines Halbleiterchips,
Figur 3 zeigt eine schematische Schnittansicht eines erfindungsgemäßen optoelektronischen Halbleiterchips,

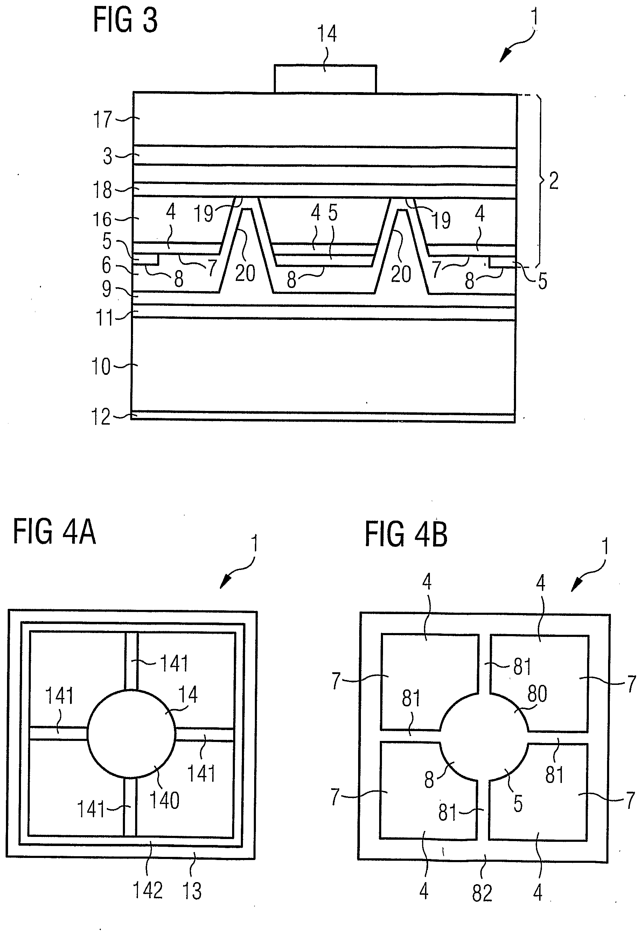

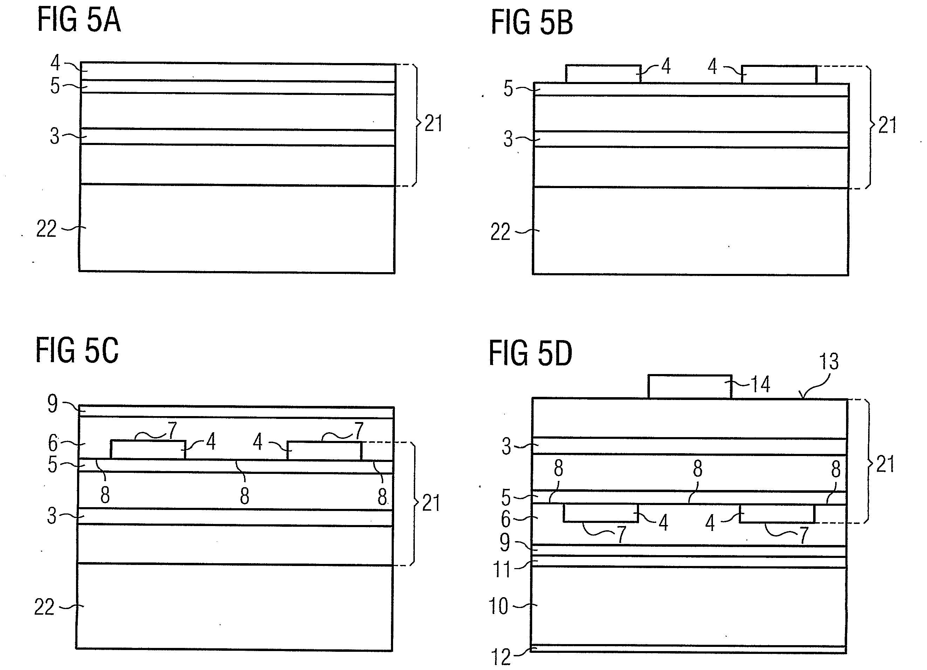

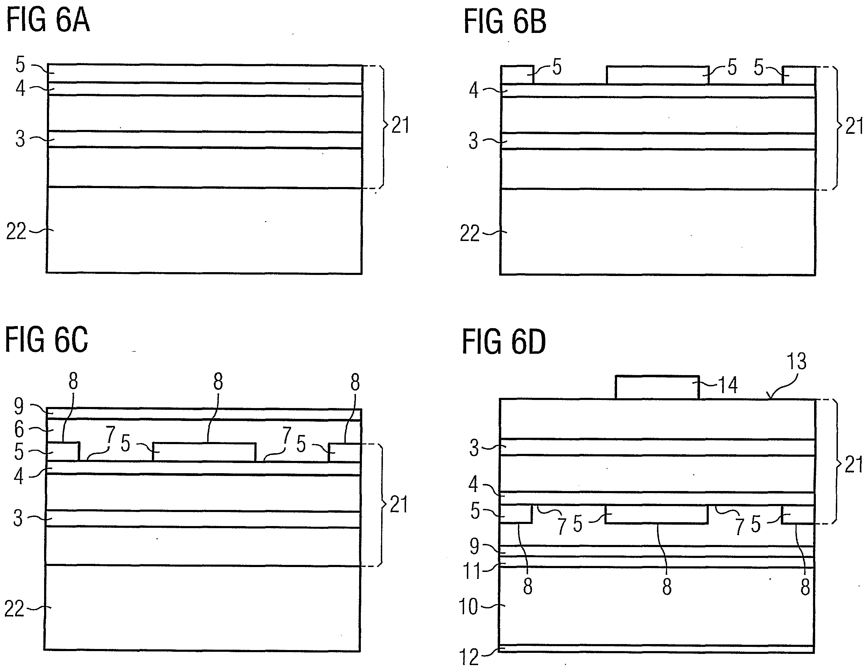

Figur 4 zeigt in den Figuren 4A und 4B schematische Aufsichten auf die Ober- beziehungsweise Unterseite eines Halbleiterkörpers für einen erfindungsgemäßen Halbleiterchip, Figur 5 zeigt anhand der schematischen Schnittansichten in den Figuren 5A bis 5D Zwischenschritte eines ersten Ausführungsbeispiel eines Verfahrens zum Ausbilden einer Kontaktstruktur für einen optoelektronischen Halbleiterchip, Figur 6 zeigt anhand der schematischen Schnittansichten in den Figuren 6A bis 6D Zwischenschritte eines weiteren Ausführungsbeispiel eines Verfahrens zum Ausbilden einer Kontaktstruktur für einen optoelektronischen Halbleiterchip.

Gleiche, gleichartige und gleich wirkende Elemente sind in den Figuren mit gleichen Bezugszeichen versehen.

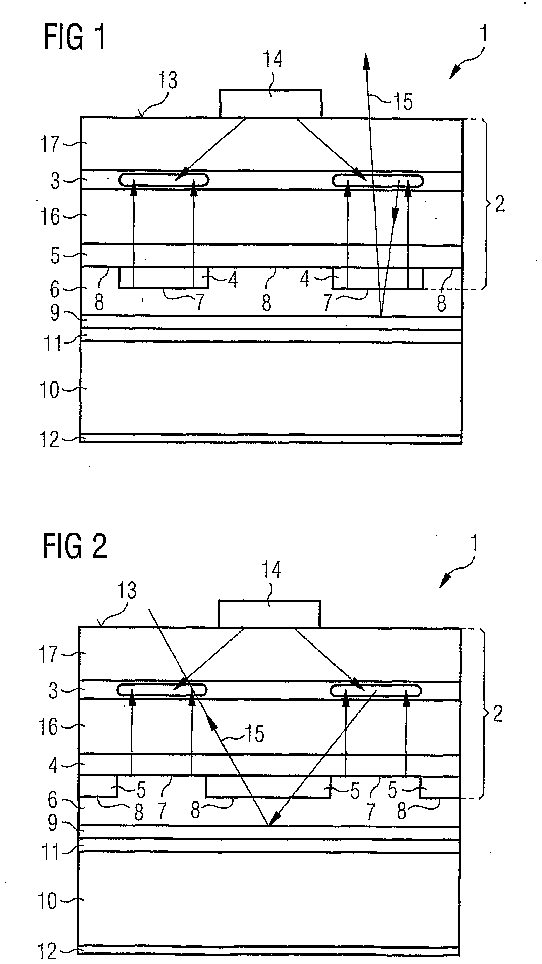

Die Figuren 1 und 2 zeigen jeweils eine schematische Schnittansicht eines Ausführungsbeispiels eines optoelektronischen Halbleiterchips 1, z.B. eines LED-Chips.

Der Halbleiterchip 1 weist jeweils einen Halbleiterkörper 2 auf, der eine Halbleiterschichtenfolge mit einem zur Strahlungserzeugung geeigneten aktiven Bereich 3 umfasst. In der Halbleiterschichtenfolge, die vorzugsweise epitaktisch, zum Beispiel mittels MOVPE (Metal-Organic Vapor Phase Epitaxy), auf einem Aufwachssubstrat (nicht dargestellt) gewachsen ist, sind eine Anschlussschicht 4 und eine Barriereschicht 5 integriert.

Auf dem Halbleiterkörper 2 ist eine strahlungsdurchlässige und elektrisch leitfähige Kontaktschicht 6 angeordnet, die an die Anschlussschicht 4 und die Barriereschicht 5 angrenzt. Im direkten Kontaktbereich der Kontaktschicht zur Anschlussschicht ist ein Anschlussbereich 7 ausgebildet, über den die Kontaktschicht 6 mit dem aktiven Bereich elektrisch leitend verbunden ist. Im direkten Kontaktbereich der Kontaktschicht zur Barriereschicht 5 ist ein Barrierebereich 8 ausgebildet.

Eine Ladungsträgerinjektion in den Halbleiterkörper 2 über den Barrierebereich 8 ist gegenüber einer Ladungsträgerinjektion in den Halbleiterkörper über den Anschlussbereich 7 erschwert. Mittels der durchgehenden und ununterbrochenen Kontaktschicht 6 kann so über die Ausbildung des Anschluss- und des Barrierebereichs vereinfacht eine bereichsweise Strominjektion in den Halbleiterkörper erzielt werden. Auf eine dielektrische Schicht zwischen dem Halbleiterkörper 2 und der Kontaktschicht 6, die für eine elektrische Kontaktbildung der Kontaktschicht zum Halbleiterkörper entsprechend ausgespart ist, kann verzichtet werden.

In einer vorteilhaften Ausgestaltung ist eine Dicke der Anschlussschicht und/oder eine Dicke der Barriereschicht größer als 10 nm, bevorzugt größer oder gleich 30 nm, besonders bevorzugt größer oder gleich 50 nm. Alternativ oder zusätzlich ist die Dicke der Barriereschicht und/oder die Dicke der Anschlussschicht mit Vorteil kleiner 1000 nm, bevorzugt kleiner oder gleich 500 nm, besonders bevorzugt kleiner oder gleich 300 nm. Derartige Dicken sind für die Anschlussschicht zur elektrischen Kontaktbildung zur Kontaktschicht einerseits und für das Ausbilden einer Barriere zur Kontaktschicht mittels der Barriereschicht andererseits besonders geeignet.

Auf der dem Halbleiterkörper 2 abgewandten Seite der Kontaktschicht 6 ist eine elektrisch leitfähige Spiegelschicht 9 angeordnet. Die Spiegelschicht ist vorzugsweise als durchgehende, ununterbrochene Schicht ausgeführt. Weiterhin grenzt die Spiegelschicht 9 vorzugsweise, insbesondere vollflächig, an die Kontaktschicht 6 an.

Die Kontaktschicht 6 ist mit Vorteil durchgehend zwischen der Spiegelschicht 9 und dem Halbleiterkörper 2 angeordnet. Ein direkter Kontakt zwischen dem Halbleitermaterial des Halbleiterkörpers 2 und der Spiegelschicht 9 kann so vermieden werden. Die Gefahr einer reflektivitätsmindernden Legierungsbildung aus dem Material der Spiegelschicht und dem Halbleitermaterial kann so verringert werden. Die Spiegelschicht kann somit über ihren gesamten lateralen Verlauf vereinfacht eine gleichbleibend hohe Reflektivität aufweisen.

Der Halbleiterkörper 2 ist weiterhin als Dünnfilm-Halbleiterkörper ausgeführt, bei dem das Aufwachssubstrat für die Halbleiterschichtenfolge von der Halbleiterschichtenfolge bereichsweise (nicht dargestellt) oder vollständig entfernt ist.

Zur mechanischen Stabilisierung des Dünnfilm-Halbleiterkörpers 2 ist dieser auf einem Träger 10 angeordnet, der vom Aufwachssubstrat der Halbleiterschichtenfolge verschieden ist. Der Halbleiterchip 1 ist somit als Dünnfilm-Halbleiterchip ausgebildet.

Zur Befestigung des Dünnfilm-Halbleiterkörpers 2 auf dem Träger 10 ist zwischen der Spiegelschicht 9 und dem Träger eine Verbindungsschicht 11 angeordnet. Die Verbindungsschicht 11 und/oder der Träger 10 sind vorzugsweise elektrisch leitfähig ausgebildet, so dass eine elektrische Kontaktierung des Halbleiterchips 1 durch den Träger 10, die Verbindungsschicht 11, die Spiegelschicht 9 und die Kontaktschicht 6 erfolgen kann.

Auf der der Kontaktschicht 6 abgewandten Seite der Spiegelschicht 9, insbesondere auf der der Kontaktschicht 6 abgewandten Seite des Trägers 10 ist eine Montageelektrode 12 angeordnet. Mittels der Montageelektrode 12 kann der Halbleiterchip 1 auf einem externen Anschlussleiter, beispielsweise einem Anschlussleiter eines oberflächenmontierbaren Bauelements oder dem Anschlussleiter einer Leiterplatte, angeordnet, elektrisch leitend mit diesem verbunden und insbesondere auf diesem befestigt werden werden.

Auf einer der Kontaktschicht 6 abgewandten Oberseite 13 des Halbleiterchips 1 ist eine Elektrode 14 angeordnet. Die Elektrode 14 ist vorzugsweise als Bondelektrode ausgeführt und zur elektrisch leitenden Verbindung mit einem Bonddraht vorgesehen, über den der Halbleiterchip 1 mit einem weiteren externen Anschlussleiter elektrisch leitend verbunden werden kann. Die Elektrode 14 und die Montageelektrode 12 können jeweils als Metallisierung ausgeführt sein.

Im Betrieb des Chips werden über die Elektroden 12 und 14 Ladungsträger in den aktiven Bereich 3 injiziert, welche dort unter Strahlungsemission rekombinieren können. Über die Elektrode 14 und die Kontaktschicht 6 in den Halbleiterkörper 2 injizierte Ladungsträger sind über entsprechende Pfeile angedeutet.

Mittels der Ausgestaltung und der Anordnung des Anschlussbereichs 7 kann die Strahlungserzeugung im aktiven Bereich 3 auf dafür besonders geeignete Bereiche konzentriert werden. In Zonen des aktiven Bereichs 3, die in vertikaler Richtung vom aktiven Bereich aus gesehen von der Elektrode 14 überdeckt werden, erzeugte Strahlung wird mit erhöhter Wahrscheinlichkeit in der Elektrode 14 absorbiert. Der Anschlussbereich 7 ist daher bevorzugt in lateraler Richtung von der Elektrode 14 beabstandet. Zweckmäßigerweise überdeckt der Barrierebereich 8 die Elektrode 14, insbesondere vollständig. Um einer Strahlungserzeugung unterhalb der Elektrode 14 weitergehend vorzubeugen, ist der Barrierebereich 8 in einem (Teil)Bereich, der sich mit der Elektrode 14 gegenseitig überdeckt, gegenüber der lateralen Ausdehnung der Elektrode 14 lateral verbreitert. Einer Strahlungserzeugung unterhalb der Elektrode 14 aufgrund der Stromaufweitung im Halbleiterkörper wird so weitergehend vorgebeugt.

Im Betrieb des Halbleiterchips 1 ist die Strahlungserzeugung auf nicht von der Elektrode 14 überdeckte Bereiche des aktiven Bereichs 3 konzentriert - vergleiche die in den Figuren 1 und 2 umgrenzten Gebiete, in denen über die Elektrode 14 und den Anschlussbereich 7 in den Halbleiterkörper injizierte Ladungsträger unter Strahlungserzeugung rekombinieren. Diese Gebiete sind von der Elektrode 14 zweckmäßigerweise lateral beabstandet.

Vom aktiven Bereich 3 ausgehend in Richtung der Kontaktschicht 6 verlaufende Strahlung kann durch die strahlungsdurchlässige Kontaktschicht hindurchtreten und auf die Spiegelschicht 9 treffen. Mittels der Spiegelschicht 9 kann diese Strahlung in den Halbleiterkörper 2 zurückreflektiert werden und über die der Spiegelschicht abgewandte Oberseite 13 des Halbleiterkörpers 2 aus dem Halbleiterchip 1 auskoppeln. Dies ist anhand des Strahls 15 exemplarisch angedeutet.

Mittels der Spiegelschicht 9 kann die Absorption von Strahlung in auf der dem aktiven Bereich 3 abgewandten Seite der Spiegelschicht angeordneten Elementen, etwa der Verbindungsschicht 11 oder dem Träger 10, verringert werden und zugleich die über die Oberseite 13 aus dem Halbleiterkörper austretende Strahlungsleistung erhöht werden.

Im lateralen Randbereich des Halbleiterkörpers und insbesondere des aktiven Bereichs 3 ist die Gefahr einer nichtstrahlenden Rekombination von Ladungsträgern besonders hoch. Der Barrierebereich 8 überdeckt daher den Randbereich des aktiven Bereichs, so dass eine Ladungsträgerinjektion über die Kontaktschicht 6 in den Halbleiterkörper 2 zum Randbereich des aktiven Bereichs vermindert wird. Die Barriereschicht kann den Halbleiterkörper 2 insbesondere lateral begrenzen.

Der aktive Bereich 3 ist zwischen einer ersten Halbleiterschicht 16 und einer zweiten Halbleiterschicht 17 angeordnet oder ausgebildet, die unterschiedliche Leitungstypen aufweisen (n-leitend bzw. p-leitend). Vorzugsweise sind die Halbleiterschichten 16 und 17 als Mantelschichten ausgebildet. Eine Mantelschicht kann den Einschluss von Ladungsträgern im aktiven Bereich und somit die Konversionseffizienz von elektrischer Leistung und Strahlungsleistung des Halbleiterchips erhöhen.

Gegebenenfalls kann auf eine separate Anschlussschicht verzichtet werden und die Halbleiterschicht 16 kann als Anschlussschicht dienen.

Insgesamt kann mittels der Erfindung ein oberflächenstrahlender Dünnfilm-Halbleiterchip ausgebildet werden, der, wie bereits weiter oben erläutert, eine vereinfacht herstellbare Kontaktstruktur zur bereichsweisen Strominjektion in den Halbleiterkörper und eine hohe Auskoppeleffizienz aufweist.

In einer bevorzugten Ausgestaltung enthält der Halbleiterkörper, insbesondere der aktive Bereich 3, die Anschlussschicht 4, die Barriereschicht 5, die erste Halbleiterschicht 16 und/oder die zweite Halbleiterschicht 17 ein III-V-Halbleitermaterial. Mittels derartiger Halbleitermaterialien kann ein Halbleiterchip besonders hoher interner Quanteneffizienz gebildet werden. Weiterhin ist der Halbleiterchip bevorzugt zur Erzeugung sichtbarer Strahlung ausgebildet.

Die Kontaktschicht 6 ist vorzugsweise als TCO-Kontaktschicht ausgeführt. TCO-Materialien zeichnen sich neben einer hohen Strahlungsdurchlässigkeit auch durch hohe elektrische Leitfähigkeit aus.

Ein Unterschied zwischen dem in Figur 1 und dem in Figur 2 gezeigten Ausführungsbeispiel ist in der Anordnung und Ausbildung der Anschlussschicht und der Barriereschicht gegeben.

Im nicht erfindungsgemäßen Ausführungsbeispiel gemäß Figur 1 ist die Barriereschicht 5 als durchgehende Schicht ausgeführt und zwischen der Anschlussschicht 4 und dem aktiven Bereich angeordnet. Die Anschlussschicht 4 ist bereichsweise ausgespart, so dass die Kontaktschicht durch die Anschlussschicht 4 hindurchtreten kann und durch direkten Kontakt mit der Barriereschicht 5 den Barrierebereich 8 ausbildet. Im Unterschied hierzu ist im Ausführungsbeispiel gemäß Figur 2 die Anschlussschicht 4 als durchgehende Schicht ausgeführt und zwischen der Barriereschicht 5 und dem aktiven Bereich angeordnet. Die Barriereschicht 5 ist hierbei zur Ausbildung des Anschlussbereichs 7 durch direkten Kontakt der Kontaktschicht zur Anschlussschicht bereichsweise ausgespart.

Der elektrische Kontaktwiderstand der Kontaktschicht 6 zu der Barriereschicht 5 ist bei beiden Ausführungsbeispielen gegenüber dem Kontaktwiderstand der Kontaktschicht 6 zur Anschlussschicht 4 gezielt erhöht. Der Anschlussbereich 7 und der Barrierebereich 8 sind bezüglich der Kontaktschicht 6 parallel geschaltet, so dass aufgrund des erhöhten Kontaktwiderstandes über die Barriereschicht erheblich weniger Ladungsträger in den Halbleiterkörper injiziert werden als über die Anschlussschicht. Hierfür sind die Anschlussschicht 4 und die Barriereschicht 5 vorzugsweise unterschiedlich voneinander ausgebildet.

Bevorzugt weist die Anschlussschicht den gleichen Leitungstypen auf wie die erste Halbleiterschicht 16, die zwischen dem aktiven Bereich und der Anschlussschicht angeordnet ist, zum Beispiel p-leitend.

Im Folgenden werden für einen Halbleiterchip 1, dessen aktiver Bereich ein Phosphid-Verbindungshalbleitermaterial, insbesondere InGaAlP, enthält, besonders geeignete Ausgestaltungen für einige Elemente des Halbleiterchips angegeben.

Die Kontaktschicht 6 ist bevorzugt als ZnO-Schicht ausgeführt. Gegebenenfalls kann die Kontaktschicht zur Erhöhung der Leitfähigkeit dotiert sein. Für ZnO eignet sich hierbei zum Beispiel Al.

Als Anschlussschicht 4 für eine ZnO-Kontaktschicht zum Halbleiterkörper ist eine p-leitende, z.B. Mg dotierte, (Al)GaAs-Schicht mit einer Dotierstoffkonzentration von größer oder gleich $5*10^{15}$ 1/($cm^3$), bevorzugt von $1*10^{16}$ 1/($cm^3$) oder mehr, besonders bevorzugt von $1*10^{17}$ 1/($cm^3$) oder mehr, besonders geeignet. Da GaAs im sichtbaren Spektralbereich absorbiert, ist eine AlGaAs-Schicht als Anschlussschicht für einen sichtbare Strahlung erzeugenden aktiven Bereich besonders zweckmäßig. Über den Al-Gehalt kann die Bandlücke der AlGaAs-Schicht derart angepasst werden, dass eine Absorption von Strahlung in der Anschlussschicht vermindert oder vollständig vermieden wird. Der Al-Gehalt beträgt bevorzugt 40% oder weniger.

Eine Au- oder AuZn-Spiegelschicht zeichnet sich für mit Phosphid-Verbindungshalbleitermaterialien erzeugbare Strahlung, insbesondere vom gelben bis in den roten Spektralbereich, durch besonders hohe Reflektivitäten aus.

Der Träger 10 kann Germanium oder GaAs enthalten oder daraus bestehen.

Weiterhin kann aufgrund des Verzichts auf ein dielektrisches Material zur Definition der Kontaktstruktur der thermische Widerstand zwischen der Spiegelschicht und dem Halbleiterkörper verringert werden. ZnO beispielsweise weist eine höhere thermische Leitfähigkeit (0,54 W/(Kcm)) als ein Siliziumnitrid ($SiN_x$: typischerweise 0,1 W/(Kcm) bis 0,2 W/(Kcm)) auf. In der Folge kann die Gefahr einer wärmestaubedingten Effizienzminderung oder einer Schädigung des Halbleiterchips verringert werden. Besonders stark bemerkbar macht sich dies bei einem Halbleiterchip, bei dem auf den Träger 10 verzichtet ist oder bei dem der Träger stark gedünnt ist.

Gegenüber einem Halbleiterchip 1 mit dielektrischem Material zur Definition von lokalen elektrischen Kontaktstellen kann der thermische Widerstand des Chips um bis zu 50% verringert werden.

Die Verbindungsschicht 11 kann als Lotschicht, beispielsweise als AuSn-haltige Schicht, als elektrisch leitfähige ausgeführte Klebeschicht oder als mittels eines Waferbonding-Verfahrens ausgebildete Schicht ausgeführt sein.

Die Barriereschicht 5 und die Anschlussschicht 4 können verschiedene Materialien aufweisen, wobei das Material der Kontaktschicht 6 elektrisch besser an das Material der Anschlussschicht 4 als an das der Barriereschicht 5 anschließt. Beispielsweise kann im Falle einer Arsenidbasierten Anschlussschicht, wie einer (Al)GaAs-Anschlussschicht, die Barriereschicht ein Phosphid-Verbindungshalbleitermaterial, zum Beispiel InAlP oder InGaAlP, enthalten.

Weiterhin kann mittels aufeinander abgestimmter Dotierung der Anschluss- und der Barriereschicht der Kontaktwiderstand der Anschlussschicht 4 gegenüber dem der Barriereschicht 5 gezielt herabgesetzt werden. In diesem Falle können die Anschluss- und die Barriereschicht abgesehen von der Dotierung insbesondere die gleiche Materialzusammensetzung aufweisen. Mittels unterschiedlicher Materialzusammensetzungen kann ein Unterschied im Kontaktwiderstand jedoch vereinfacht verstärkt werden.

Zur Erhöhung des Kontaktwiderstandes der Barriereschicht 5 zur Kontaktschicht 6 gegenüber dem Kontaktwiderstand der Kontaktschicht 6 zur Anschlussschicht 4 kann die Barriereschicht für einen von der Anschlussschicht verschiedenen Leitungstypen dotiert sein, zum Beispiel n-leitend.

Auch über eine Dotierung der Barriereschicht 5 für den gleichen Leitungstypen wie die Anschlussschicht aber mit einer geringeren Dotierstoffkonzentration kann eine vorwiegende Ladungsträgerinjektion in den Halbleiterkörper über den Anschlussbereich in den Halbleiterkörper 2 erzielt werden. Bevorzugt weist die Barriereschicht eine Dotierstoffkonzentration von weniger als $5*10^{15}$ 1/($cm^3$) auf. Gegebenenfalls kann der gleiche Dotierstoff oder es können verschiedene Dotierstoffe für die Anschluss- und die Barriereschicht eingesetzt werden.

Alternativ zur Beeinflussung des Kontaktwiderstands über die Dotierstoffkonzentration oder den Leitungstyp kann die Barriereschicht undotiert ausgeführt sein, wodurch bei dotierter Ausführung der Anschlussschicht ebenfalls eine Erhöhung des Kontaktwiderstandes der Barriereschicht zur Kontaktschicht erzielt werden kann. Auch hierbei können die Anschluss- und die Barriereschicht abgesehen von der Dotierung gegebenenfalls die gleiche Materialzusammensetzung aufweisen. Mittels unterschiedlicher Materialzusammensetzungen kann ein Unterschied im Kontaktwiderstand jedoch vereinfacht verstärkt werden.

Da die Ladungsträger nach der Injektion in den Halbleiterkörper 2 in dem Ausführungsbeispiel gemäß Figur 1 noch die durchgehende Barriereschicht durchdringen müssen, um zum aktiven Bereich zu gelangen, ist beim Ausführungsbeispiel gemäß Figur 1 die Barriereschicht 5 vorzugsweise undotiert und entsprechend dünn oder mit dem Leitungstyp der Anschlussschicht 4, jedoch mit einer geringeren Dotierstoffkonzentration, ausgeführt. Zum widerstandsarmen Ladungsträgertransport innerhalb des Halbleiterkörpers sind in der Regel geringere Dotierstoffkonzentrationen ausreichend als für eine effiziente, barrierearme Ladungsträgerinjektion in den Halbleiterkörper.

Zur Optimierung der Reflektivität der reflektierenden Kontaktstruktur mit der Kontaktschicht und der Spiegelschicht weist die Kontaktschicht bevorzugt eine Dicke auf, die größer ist als $\lambda/(4n_k)$, wobei $\lambda$ eine charakteristische Emissionswellenlänge, etwa eine der weiter oben genannten Wellenlängen, der im aktiven Bereich erzeugten und insbesondere der aus dem Halbleiterchip ausgekoppelten Strahlung ist. $n_k$ bezeichnet den Brechungsindex des Materials der Kontaktschicht. Beispielsweise ist die Dicke der Kontaktschicht größer als 400 nm. Bevorzugt ist eine minimale Dicke der Kontaktschicht derart ausgebildet.

Neben der guten elektrischen Anbindung an den Halbleiterkörper im Anschlussbereich 7 kann so auch eine über einen weiten Bereich von Einfallswinkeln optimierte Reflektivität der reflektierenden Kontaktstruktur erzielt werden. Zur Kontaktbildung alleine kann jedoch bereits eine Kontaktschicht mit einer Dicke von weniger als $\lambda/(4n_k)$, z.B. von 200 nm oder weniger, ausreichen.

In einer weiteren bevorzugten Ausgestaltung umfasst der aktive Bereich eine Doppelheterostruktur oder eine Ein- oder Mehrfach-Quantentopfstruktur. Mittels derartiger Strukturen kann die Quanteneffizienz des aktiven Bereichs vorteilhaft erhöht werden.

Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren oder erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Figur 4 zeigt schematische Aufsichten für einen Halbleiterchip, etwa einen Chip gemäß Figur 1 oder Figur 2. Figur 4A zeigt hierbei eine Aufsicht auf die Oberseite 13 des Halbleiterkörpers 2, und Figur 4B eine Aufsicht auf die Anschlussschicht 4 und die Barriereschicht 5 des Halbleiterkörpers 2.

Die Elektrode 14 weist einen Elektrodenbereich 140 auf, der zur Verbindung mit einem Bonddraht vorgesehen ist. Mit dem Bereich 140 elektrisch leitend verbunden sind Stege 141, die zur Stromaufweitung dienen. Mittels der Stege 141 ist der Bereich 140 elektrisch leitend mit einem Elektrodenrahmen 142 verbunden. Der Elektrodenrahmen 142 ist im Randbereich der Oberseite 13 angeordnet. In den Schnittansichten gemäß den Figuren 1 und 2 sind der Elektrodenrahmen bzw. die Elektrodenstege nicht explizit dargestellt.

Mittels einer derartigen Elektrodenstruktur kann eine laterale Stromaufweitung vom Elektrodenbereich 140 ausgehend erzielt werden.

Wie aus Figur 4B zu entnehmen ist, ist die Form des Barrierebereichs 8 vorzugsweise auf diejenige der in Figur 4A gezeigten Elektrodenstruktur abgestimmt. Der Barrierebereich kann hierzu eine der Elektrodenstruktur entsprechende Grundgeometrie aufweisen.

Gemäß Figur 4 weist der Halbleiterchip 1 eine Mehrzahl separater Anschlussbereiche 7 und einen durchgehenden Barrierebereich 8 auf, der entsprechend der Elektrodenstruktur geformt ist. Der Barrierebereich 8 weist dementsprechend einen Bereich 80 auf, von dem ausgehend Stege 81 den Bereich 80 mit einem Barriererahmen 82 verbinden. Gegenüber der Elektrodenstruktur weisen die entsprechenden Gebiete des Barrierebereichs vorzugsweise jeweils eine größere laterale Ausdehnung auf. Der Barrierebereich ist bevorzugt derart ausgebildet, dass trotz einer Stromaufweitung im Halbleiterkörper eine Strahlungserzeugung im aktiven Bereich unterhalb der Elektrodenstruktur vermieden wird.

Weiterhin kann der Halbleiterchip gegebenenfalls eine Mehrzahl separater Barrierebereiche umfassen (nicht dargestellt). Dies ist besonders zweckmäßig, falls eine Rekombination von Ladungsträgern im Randbereich des Halbleiterkörpers unterdrückt werden soll und die Elektrode 14 lediglich den Elektrodenbereich 140 aufweist. Ein erster Barrierebereich ist dann vorzugsweise unterhalb des Elektrodenbereichs 140 und ein zweiter, räumlich von diesem getrennter Barrierebereich ist im Randbereich des Halbleiterkörpers 2 angeordnet.

Zudem kann der Anschlussbereich, insbesondere im Fall getrennter Barrierebereiche, als zusammenhängender Bereich ausgebildet sein (nicht dargestellt).

Figur 3 zeigt ein Ausführungsbeispiel eines erfindungsgemäßen optoelektronischen Halbleiterchips 1. Im Wesentlichen entspricht der Halbleiterchip 1 den in den Figuren 1 und 2 gezeigten Ausführungsbeispielen. Im Unterschied hierzu weist der Halbleiterkörper 2 eine oder eine Mehrzahl von Ausnehmungen 20 auf, die sich von der der Kontaktschicht 6 zugewandten Seite des Halbleiterkörpers 2 ausgehend in Richtung des aktiven Bereichs 3 erstrecken. Die Ausnehmungen 20 können sich insbesondere in Richtung des aktiven Bereichs 3 verjüngen.

Weiterhin durchbrechen die Ausnehmungen 20 die Anschlussschicht 4, die Barriereschicht 5 und gegebenenfalls die Halbleiterschicht 16. Die Kontaktschicht 6 erstreckt sich in die Ausnehmung hinein und kleidet diese vorzugsweise aus. Auch die Spiegelschicht 9 erstreckt sich vorzugsweise in die Ausnehmung hinein.

Zwischen dem aktiven Bereich 3 und der Kontaktschicht ist eine weitere Barriereschicht 18 angeordnet, an die die Kontaktschicht 6 in einem weiteren Barrierebereich 19 angrenzt. Die weitere Barriereschicht ist vorzugsweise p-leitend ausgebildet und/oder weist gegenüber der Anschlussschicht eine geringere Dotierstoffkonzentration gemäß den obigen Ausführungen aus.

Über die Ausnehmung und insbesondere die in dieser angeordneten Spiegelschicht kann die Winkelverteilung bezogen auf die Oberseite 13 von an der Spiegelschicht in den Halbleiterkörper zurück reflektierter Strahlung gegenüber einer Reflexion an einer durchgehend ebenen Spiegelschicht breiter gestreut werden. Die Wahrscheinlichkeit, dass Strahlung mit einem Winkel kleiner als einem Grenzwinkel der Totalreflexion auf die Oberseite 13 des Halbleiterkörpers 2 trifft und damit aus dem Halbleiterkörper auskoppeln kann, wird hierdurch erhöht. Dementsprechend kann der Anteil an im Halbleiterkörper fortgesetzt totalreflektierter Strahlung mittels der Ausnehmung 20 verringert werden. Insgesamt wird so die Auskoppeleffizienz des Halbleiterchips erhöht.

Die Ausnehmungen 20 können beispielsweise mittels einer Mikroprismenstruktur gebildet sein. Die Ausnehmungen 20 können beispielsweise mittels Ätzen erzeugt sein.

Es kann eine Mehrzahl separater Ausnehmungen vorgesehen sein oder eine zusammenhängende Ausnehmung vorgesehen sein.

Die Figuren 5 und 6 zeigen in den Figuren 5A bis 5D beziehungsweise 6A bis 6D jeweils ein Ausführungsbeispiel eines Verfahrens zur Herstellung einer Kontaktstruktur für einen zur Strahlungserzeugung geeigneten optoelektronischen Halbleiterchip. Das Verfahren zur Ausbildung der Kontaktstruktur wird hierbei im Zusammenhang mit der Herstellung eines Halbleiterchips beschrieben, wobei sich das Verfahren gemäß Figur 5 für einen Halbleiterchip gemäß Figur 1 und das Verfahren gemäß Figur 6 für einen Halbleiterchip gemäß Figur 2 eignet.

Zunächst wird in beiden Verfahren eine Halbleiterschichtenfolge 21 bereitgestellt, die eine Anschlussschicht 4 und eine Barriereschicht 5 umfasst, Figuren 5A und 6A. Weiterhin weist die Halbleiterschichtenfolge einen zur Strahlungserzeugung geeigneten aktiven Bereich 3 auf. Die Halbleiterschichtenfolge 21 ist auf einem Substrat 22 angeordnet. Das Substrat 22 ist vorzugsweise das Aufwachssubstrat auf dem die Halbleiterschichtenfolge 21 mit der monolithisch in die Halbleiterschichtenfolge integrierten Anschlussschicht und der monolithisch integrierten Barriereschicht, z.B. mittels MOVPE, epitaktisch gewachsen wurde. Die Anschlussschicht 4 und die Barriereschicht 5 sind bevorzugt auf der dem Substrat 22 abgewandten Seite des aktiven Bereichs angeordnet.

Für eine Halbleiterschichtenfolge mit einem aktiven Bereich auf Phosphid-Verbindungshalbleitermaterialbasis eignet sich beispielsweise GaAs als Aufwachssubstrat. Die Halbleiterschichtenfolge 21 ist insbesondere zur Ausbildung eines Halbleiterkörpers für den optoelektronischen Halbleiterchip vorgesehen.

Die Anschlussschicht 4 und die Barriereschicht 5 sind derart ausgebildet, dass sie gegenüber einem auf die vorgefertigte Halbleiterschichtenfolge aufzubringenden vorgegebenen Material oder einer vorgegebenen Materialzusammensetzung für eine Kontaktschicht unterschiedliche Kontaktwiderstände, vorzugsweise vorgegebene Kontaktwiderstände aufweisen. Der Kontaktwiderstand der Kontaktschicht zur Barriereschicht ist dabei zweckmäßigerweise größer als der Kontaktwiderstand der Anschlussschicht zur vorgegebenen Kontaktschicht.

Gemäß Figur 5A ist die Barriereschicht 5 zwischen dem aktiven Bereich 3 und der Anschlusssicht angeordnet, wohingegen gemäß Figur 6A die Anschlussschicht zwischen dem aktiven Bereich und der Barriereschicht angeordnet ist.

Daraufhin wird die Anschlussschicht 4 bereichsweise entfernt, so dass die Barriereschicht 5 zur Ausbildung eines Barrierebereichs zur Kontaktschicht freigelegt wird, Figur 5B beziehungsweise die Barriereschicht 5 wird bereichsweise entfernt, so dass die Anschlussschicht 4 zur Ausbildung eines Anschlussbereichs zur Kontaktschicht freigelegt wird, Figur 6B. Für das bereichsweise Entfernen eignet sich beispielsweise ein Ätzverfahren unter Einsatz einer geeignet strukturierten Maske.

Hierbei werden jeweils vorgegebene Bereiche der Anschlussschicht beziehungsweise der Barriereschicht entfernt. Im Ausführungsbeispiel nach Figur 5 werden die Bereiche der Anschlussschicht 4 entfernt, in denen im fertigen Halbleiterchip eine Strominjektion in den Halbleiterkörper des Chips unerwünscht ist. Im Verfahren gemäß Figur 6 dagegen werden die Bereiche der Anschlussschicht freigelegt, in denen im fertigen Halbleiterchip eine Strominjektion erwünscht ist. Mittels dieser Strukturierung der Halbleiterschichtenfolge werden insbesondere bereits der Barrierebereich und der Anschlussbereich für den Halbleiterchip definiert.

Auf die dem Substrat 22 abgewandte Seite der Halbleiterschichtenfolge 21 wird daraufhin eine Kontaktschicht 6 aufgebracht, die in dem Barrierebereich 8 an die Barriereschicht 5 und in dem Anschlussbereich 7 an die Anschlussschicht 4 angrenzt. Die Kontaktschicht 6 ist mit dem aktiven Bereich über den Anschlussbereich 7 elektrisch leitend verbunden und für im aktiven Bereich erzeugte Strahlung durchlässig. Eine TCO-Kontaktschicht 6, insbesondere eine ZnO-Kontaktschicht, ist hierbei besonders geeignet. Die Kontaktschicht 6 kann mittels Sputtern oder PECVD und insbesondere in einem Vakuumprozess auf der Halbleiterschichtenfolge 21 abgeschieden werden.

Nach dem Aufbringen der Kontaktschicht 6 kann der Schichtverbund noch gesintert werden, wobei vorzugsweise die elektrischen Kontakteigenschaften der Kontaktschicht zur Anschlussschicht 4 verbessert werden. Der Schichtverbund mit der Halbleiterschichtenfolge und der auf diese aufgebrachten Kontaktschicht kann beispielsweise fünf Minuten oder länger, z.B. sieben Minuten, bei einer Temperatur von 450 °C gesintert werden.

Da die Kontaktschicht 6 elektrisch im Wesentlichen nicht an die Barriereschicht sondern nur an die Anschlussschicht 4 anschließt, kann die Kontaktschicht vollflächig auf die Halbleiterschichtenfolge aufgebracht werden. Auf eine nachfolgende Strukturierung oder eine strukturierte Aufbringung der Kontaktschicht kann verzichtet werden, wobei trotzdem eine lokale Strominjektion erzielt werden kann. Auch auf eine strukturierte dielektrische Schicht zwischen der Kontaktschicht und dem Barrierebereich mit Stromdurchlassöffnungen für eine lokale Strominjektion in die Halbleiterschichtenfolge kann verzichtet werden.

Daraufhin wird auf die von der Halbleiterschichtenfolge 21 abgewandte Seite der Kontaktschicht 6 eine Spiegelschicht 9 aufgebracht. Die Spiegelschicht ist vorzugsweise metallisch oder als metallhaltige Legierung ausgeführt Die Spiegelschicht kann, z.B. mittels Aufdampfen oder Sputtern, auf den Schichtverbund, insbesondere in einem Vakuumprozess, abgeschieden werden. Beispielsweise enthält die Spiegelschicht oder besteht die Spiegelschicht aus Au oder AuZn. Die Spiegelschicht kann vollflächig auf den Schichtverbund abgeschieden werden.

Die hieraus resultierende Struktur ist in den Figuren 5C beziehungsweise 6C schematisch dargestellt. Aufgrund der durchgehend ausgeführten Kontaktschicht 6 wird ein direkter Kontakt zwischen der Spiegelschicht 9 und dem Halbleitermaterial der Halbleiterschichtenfolge verhindert, wodurch eine reflektivitätsmindernde Legierungsbildung zwischen der Spiegelschicht und dem Halbleitermaterial vermieden wird.

Auf der dem Substrat abgewandten Seite der Spiegelschicht 9 wird die Schichtstruktur nachfolgend mittels einer Verbindungsschicht 11 auf einem Träger 10 befestigt. Der Träger kann beispielsweise Ge oder GaAs enthalten. Die Verbindungsschicht 11 ist vorzugsweise elektrisch leitfähig ausgebildet. Die Verbindungsschicht 11 kann als Lotschicht, elektrisch leitfähig ausgebildete Klebeschicht oder eine in einem Waferbonding-Verfahren ausgebildete Schicht ausgeführt sein.

Daraufhin wird das Substrat zumindest bereichsweise (nicht dargestellt) oder vollständig von der Halbleiterschichtenfolge 21 entfernt, beispielsweise mittels Ätzen oder eines Laserablöseverfahrens. Hierbei wird bevorzugt zumindest ein Bereich der der Kontaktschicht 6 abgewandten Oberseite 13 der Halbleiterschichtenfolge 21 freigelegt, auf dem nachfolgend eine Elektrode 14 aufgebracht, insbesondere abgeschieden werden kann. Vorzugsweise wird das Substrat 22 jedoch vollständig entfernt. Die Bauhöhe des Chips kann so verringert werden.

Auf die der Halbleiterschichtenfolge 21 abgewandte Seite der Kontaktschicht 6, insbesondere die der Halbleiterschichtenfolge 21 abgewandte Seite des Trägers 10, wird zu einem geeigneten Zeitpunkt eine Montageelektrode 12, z.B. eine Metallisierung, zur Montage des Halbleiterchips auf einem externen elektrischen Anschlussleiter aufgebracht. Der mittels des jeweiligen Verfahrens hergestellte Halbleiterchip 1 mit einem durch die Halbleiterschichtenfolge 21 gebildeten Halbleiterkörper ist in den Figuren 5D beziehungsweise 6D schematisch dargestellt.

Das Verfahren kann selbstverständlich auch zur gleichzeitigen Herstellung einer Mehrzahl von Halbleiterchips im Waferverbund eingesetzt werden, wobei die Chips besonders einfach und kostengünstig mit einer Kontaktstruktur für eine lokale Strominjektion hergestellt werden können. Die Kontaktschicht kann hierbei vollflächig auf den gesamten Wafer abgeschieden werden, wobei ein elektrischer Anschluss über in der Halbleiterschichtenfolge definierte Anschlussbereiche erfolgt.

## Patentansprüche

1. Optoelektronischer Halbleiterchip (1) mit einem Halbleiterkörper (2), der eine Halbleiterschichtenfolge und einen zur Strahlungserzeugung geeigneten aktiven Bereich (3) umfasst, und
   einer auf dem Halbleiterkörper (2) angeordneten und elektrisch leitend mit dem aktiven Bereich (3) verbundenen strahlungsdurchlässigen und elektrisch leitfähigen Kontaktschicht (6), wobei
   auf der von dem aktiven Bereich (3) abgewandten Seite der Kontaktschicht (6) eine metallhaltige Spiegelschicht (9) angeordnet ist,
   die Kontaktschicht (6) über einen Anschlussbereich (7) einer Anschlussschicht (4) der Halbleiterschichtenfolge mit dem aktiven Bereich (3) elektrisch leitend verbunden ist, und
   ein elektrischer Kontaktwiderstand der Kontaktschicht (6) zur Anschlussschicht (4) der Halbleiterschichtenfolge kleiner als ein elektrischer Kontaktwiderstand der Kontaktschicht (6) zu einer Barriereschicht (5) der Halbleiterschichtenfolge ist, wobei sich die Kontaktschicht (6) über die Barriereschicht (5) der Halbleiterschichtenfolge und über die Anschlussschicht (4) der Halbleiterschichtenfolge erstreckt,
   die Barriereschicht (5) zwischen der Kontaktschicht (6) und der Anschlussschicht (4) angeordnet ist, und der Halbleiterkörper (2) eine Ausnehmung (20) aufweist, die die Anschlussschicht (4) und die Barriereschicht (5) durchbricht, wobei sich die Kontaktschicht (6) in die Ausnehmung hinein erstreckt.

2. Halbleiterchip nach Anspruch 1,
   bei dem die Kontaktschicht (6) in einem Barrierebereich (8) an die Barriereschicht (5) und/oder bei dem die Kontaktschicht in dem Anschlussbereich (7) an die Anschlussschicht (4) angrenzt.

3. Halbleiterchip nach einem der Ansprüche 1 oder 2, bei dem die Anschlussschicht (4) dotiert ausgeführt ist und die Barriereschicht (5) undotiert ausgeführt ist.

4. Halbleiterchip nach einem der Ansprüche 1 oder 2,

bei dem die Anschlussschicht (4) und die Barriereschicht (5) den gleichen Leitungstypen aufweisen, wobei eine Dotierstoffkonzentration der Anschlussschicht größer ist als eine Dotierstoffkonzentration der Barriereschicht.

5. Halbleiterchip nach einem der Ansprüche 1 bis 4, bei dem der Halbleiterchip einen Träger (10) umfasst, auf dem die Halbleiterschichtenfolge angeordnet ist, die Kontaktschicht (6) zwischen der Halbleiterschichtenfolge und dem Träger angeordnet ist, und der Träger auf der dem aktiven Bereich (3) abgewandten Seite der Spiegelschicht (9) angeordnet ist.

6. Halbleiterchip nach einem der Ansprüche 1 bis 5, bei dem

> a) die Spiegelschicht (9) an die Kontaktschicht (6) angrenzt, und/oder
> b) die Kontaktschicht durchgehend zwischen der Spiegelschicht und dem Halbleiterkörper (2) angeordnet ist, so dass mittels der Kontaktschicht ein direkter Kontakt des Halbleiterkörpers mit der Spiegelschicht vermieden wird.

7. Halbleiterchip nach einem der Ansprüche 2 bis 6, der eine Mehrzahl von Barrierebereichen (80,81,82) aufweist, wobei einer dieser Barrierebereiche (80) eine auf der von dem Barrierebereich abgewandten Seite des Halbleiterkörpers (2) angeordnete Elektrode (14) des Halbleiterchips überdeckt und ein anderer Barrierebereich (82) im Randbereich des Halbleiterchips angeordnet ist.

8. Halbleiterchip nach Anspruch 7, bei dem die Barrierebereiche (80,81,82) zusammenhängend ausgeführt sind.

9. Halbleiterchip nach Anspruch 7 oder 8, der eine Mehrzahl gesonderter Anschlussbereiche aufweist.

10. Halbleiterchip nach Anspruch 1, bei dem zwischen dem aktiven Bereich (3) und der Kontaktschicht (6) eine weitere Barriereschicht (18) angeordnet ist.

11. Halbleiterchip nach einem der vorhergehenden Ansprüche, bei dem die Kontaktschicht (6) ein strahlungsdurchlässiges und elektrisch leitfähiges Oxid enthält.

12. Halbleiterchip nach einem der vorhergehenden Ansprüche, bei dem die Kontaktschicht (6) ZnO enthält.

13. Halbleiterchip nach einem der vorhergehenden Ansprüche, sprüche, bei dem die Anschlussschicht (4) auf einem Arsenid-Verbindungshalbleitermaterial und die Barriereschicht (5) auf einem Phosphid-Verbindungshalbleitermaterial basiert.

## Claims

1. An optoelectronic semiconductor chip (1) having a semiconductor body (2), which comprises a semiconductor layer sequence and an active region (3) suitable for generating radiation, and
a radiation-permeable and electrically conductive contact layer (6) arranged on the semiconductor body (2) and electrically conductively connected to the active region (3), wherein
on the side of the contact layer (6) remote from the active region (3) a metal-containing mirror layer (9) is arranged,
the contact layer (6) is electrically conductively connected to the active region (3) via a connection region (7) of a connection layer (4) of the semiconductor layer sequence, and an electrical contact resistance of the contact layer (6) to the connection layer (4) of the semiconductor layer sequence is smaller than an electrical contact resistance of the contact layer (6) to a barrier layer (5) of the semiconductor layer sequence, in which the contact layer (6) extends over the barrier layer (5) of the semiconductor layer sequence and over the connection layer (4) of the semiconductor layer sequence, the barrier layer (5) is arranged between the contact layer (6) and the connection layer (4), and
the semiconductor body (2) has a recess (20) which breaks through the connection layer (4) and the barrier layer (5), the contact layer (6) extending into the recess.

2. Semiconductor chip according to claim 1, in which the contact layer (6) in a barrier region (8) adjoins the barrier layer (5) and / or in which the contact layer in the connection region (7) adjoins the connection layer (4).

3. Semiconductor chip according to one of claims 1 or 2, in which the connection layer (4) is designed to be doped and the barrier layer (5) is designed to be undoped.

4. Semiconductor chip according to one of claims 1 or 2, in which the connection layer (4) and the barrier layer (5) have the same conductivity type, wherein a dopant concentration of the connection layer is greater than a dopant concentration of the barrier layer.

5. Semiconductor chip according to one of claims 1 to 4, in which the semiconductor chip comprises a carrier (10), on which the semiconductor layer sequence is arranged, the contact layer (6) is arranged between the semiconductor layer sequence and the carrier, and the carrier is arranged on the side of the mirror layer (9) facing away from the active region (3).

6. The semiconductor chip according to one of claims 1 to 5, wherein

a) the mirror layer (9) is adjacent to the contact layer (6), and / or
b) the contact layer is arranged continuously between the mirror layer and the semiconductor body (2), so that direct contact of the semiconductor body with the mirror layer is avoided by means of the contact layer.

7. Semiconductor chip according to one of claims 2 to 6, which has a plurality of barrier regions (80, 81, 82), wherein one of these barrier regions (80) covers an electrode (14) of the semiconductor chip arranged on the side of the semiconductor body (2) remote from the barrier region and another barrier region (82) is arranged in the edge region of the semiconductor chip.

8. Semiconductor chip according to claim 7, in which the barrier areas (80,81,82) are made contiguous.

9. Semiconductor chip according to claim 7 or 8, having a plurality of separate connection areas.

10. Semiconductor chip according to claim 1, in which a further barrier layer (18) is arranged between the active region (3) and the contact layer (6).

11. Semiconductor chip according to one of the preceding claims, in which the contact layer (6) contains a radiation-transmissive and electrically conductive oxide.

12. Semiconductor chip according to one of the preceding claims, in which the contact layer (6) contains ZnO.

13. Semiconductor chip according to one of the preceding claims, in which the connection layer (4) is based on an arsenide compound semiconductor material and the barrier layer (5) on a phosphide compound semiconductor material.

**Revendications**

1. Puce semi-conductrice optoélectronique (1) comportant un corps semi-conducteur (2) comprenant une succession de couches semi-conductrices et une zone active (3) apte à générer un rayonnement, et

une couche de contact (6) électriquement conductrice et perméable au rayonnement disposée sur le corps semi-conducteur (2) et reliée à la zone active (3) de manière électriquement conductrice,
une couche miroir (9) contenant un métal étant disposée sur la face de la couche de contact (6) opposée à la zone active (3),
la couche de contact (6) étant reliée via une zone de connexion (7) d'une couche de connexion (4) de la succession de semi-conducteurs à la zone active (3), et
une résistance de contact électrique de la couche de contact (6) à la couche de connexion (4) de la succession de couches semi-conductrices étant inférieure à une résistance de contact électrique de la couche de contact à une couche barrière (5) de la succession de couches semi-conductrices, la couche de contact (6) s'étendant sur la couche barrière (5) de la succession de couches semi-conductrices et sur la couche de connexion (4) de la succession de couches semi-conductrices,
la couche barrière (5) étant disposée entre la couche de contact (6) et la couche de connexion (4) et
le corps semi-conducteur (2) comprenant un évidement (20) franchissant la couche de connexion (4) et la couche barrière (5), la couche de contact (6) s'étendant dans l'évidement.

2. Puce semi-conductrice selon la revendication 1, dans laquelle la couche de contact (6) est adjacente à la couche barrière (5) dans une zone barrière (8) et/ou dans laquelle la couche de contact est adjacente à la couche de connexion (4) dans la zone de connexion (7).

3. Puce semi-conductrice selon l'une des revendications 1 ou 2, dans laquelle la couche de connexion (4) est conçue sous forme dopée et la couche barrière (5) est conçue sous forme non-dopée.

4. Puce semi-conductrice selon l'une des revendications 1 ou 2, dans laquelle la couche de connexion (4) et la couche barrière (5) ont le même type de conductivité, une concentration de dopant de la couche de connexion étant supérieure à une concentration de dopant de la couche barrière.

5. Puce semi-conductrice selon l'une des revendications 1 à 4, dans laquelle la puce semi-conductrice comprend un support (10) sur lequel est disposée la succession de couches semi-conductrices, la couche de contact (6) étant disposée entre la succession de couches semi-conductrices et le support et le support étant disposé sur la face de la couche miroir (9) opposée à la zone active (3).

**6.** Puce semi-conductrice selon l'une des revendications 1 à 5, dans laquelle

a) la couche miroir (9) est adjacente à la couche de contact (6), et/ou
b) la couche de contact est disposée de manière continue entre la couche miroir et le corps semi-conducteur (2) de manière que grâce à la couche de contact, un contact direct du corps semi-conducteur avec la couche miroir est empêché.

**7.** Puce semi-conductrice selon l'une des revendications 2 à 6, comportant une pluralité de zones barrière (80, 81, 82), l'une desdites zones barrières (80) recouvrant une électrode (14) de la puce semi-conductrice disposée sur la face du corps semi-conducteur opposée à la zone barrière et une autre zone barrière (82) étant disposée à la périphérie de la puce semi-conductrice.

**8.** Puce semi-conductrice selon la revendication 7, dans laquelle les zones barrière (80, 81, 82) sont prévues de façon continue.

**9.** Puce semi-conductrice selon la revendication 7 ou 8, comportant une pluralité de zones de connexion séparées.

**10.** Puce semi-conductrice selon la revendication 1, dans laquelle une couche barrière (18) supplémentaire est prévue entre la zone active (3) et la couche de contact (6) .

**11.** Puce semi-conductrice selon l'une des revendications précédentes, dans laquelle la couche de contact (6) contient un oxyde perméable au rayonnement et électriquement conducteur.

**12.** Puce semi-conductrice selon l'une des revendications précédentes, dans laquelle la couche de contact (6) contient du ZnO.

**13.** Puce semi-conductrice selon l'une des revendications précédentes, dans laquelle la couche de contact (4) est basée sur un matériau semi-conducteur de connexion d'arséniure, la couche barrière (5) étant basée sur un matériau semi-conducteur de connexion de phosphure.

## FIG 1

## FIG 2

## FIG 3

## FIG 4A

## FIG 4B

FIG 5A

FIG 5B

FIG 5C

FIG 5D

## FIG 6A

## FIG 6B

## FIG 6C

## FIG 6D

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2005117147 A1
- US 5789768 A
- EP 1523047 A
- US 2001011730 A1
- US 20040135166 A1
- WO 0245217 A
- US 20040206961 A1
- EP 1592072 A2

**In der Beschreibung aufgeführte Nicht-Patentliteratur**

- **I. SCHNITZER et al.** *Appl. Phys. Lett.,* 18. Oktober 1993, vol. 63 (16), 2174-2176